# EUROPEAN PATENT APPLICATION

(11) **EP 4 770 352 A1**
(43) Date of publication of application: **01.07.2026**
(21) Application number: 23961812.7
(22) Date of filing: 19.12.2023
(51) Int. Cl.: H10H 20/851, H01L 25/075, H10H 29/14

(54) **CHIP STRUCTURE AND MANUFACTURING METHOD THEREFOR, AND DISPLAY SUBSTRATE**

(71) Applicant: BOE Technology Group Co., Ltd., Beijing 100015 (CN); Beijing BOE Technology Development Co., Ltd., Daxing District Beijing 100176 (CN)
(72) Inventor: HAN, Tianyang, Beijing 100176 (CN); LI, Wei, Beijing 100176 (CN); WANG, Mingxing, Beijing 100176 (CN); XU, Jian, Beijing 100176 (CN)
(74) Representative: Haseltine Lake Kempner LLP
(86) International application number: PCT/CN2023/140019
(87) International publication number: WO 2025/129467

(57) **Abstract**

The present application belongs to the technical field of displays. Disclosed are a chip structure and a manufacturing method therefor, and a display substrate. The chip structure comprises: a first substrate, a light-emitting unit, a color conversion unit and a surrounding dam layer. The surrounding dam layer can be arranged around the light-emitting unit, and the maximum distance between the surface of the surrounding dam layer facing away from the color conversion unit and the first substrate is greater than or equal to the maximum distance between the surface of a first semiconductor layer in the light-emitting unit facing away from the first substrate and the first substrate. Therefore, after a light waveguide phenomenon occurs inside the first semiconductor layer, light transmitted transversely within the first semiconductor layer can be blocked by the surrounding dam layer after being emitted from any position on the edge, such that the probability of light leakage in the chip structure can be effectively reduced, resulting in a better display effect of the display substrate, which is integrated with the chip structure.

## Description

### TECHNICAL FIELD

The present disclosure relates to the field of display technologies, and in particular, relates to a chip structure and a method for manufacturing the same, and a display substrate.

### BACKGROUND

With the development of the field of display technologies, a display substrate integrated with a mini light-emitting diode (LED for short) chip becomes the most advantageous new generation of display media, and has been widely used due to advantages of the mini LED chip, such as pure chroma, wide dynamic range, high brightness, high clarity, low operating voltage, low power consumption, long service life, impact resistance, large viewing angle, stable and reliable operation, and the like.

### SUMMARY

Embodiments of the present disclosure provide a chip structure and a method for manufacturing the same, and a display substrate. The technical solutions are as follows.

In an aspect, a chip structure is provided. The chip structure includes: a first substrate, light-emitting units, color conversion units, and a dam; wherein the color conversion units are disposed between the first substrate and the light-emitting units, light-emitting sides of the light-emitting units face towards the first substrate, and the dam is disposed on a side, facing away from the first substrate, of each of the color conversion units and surrounds a periphery of each of the light-emitting units;
each of the color conversion units includes a limiting dam and an optical functional portion, wherein an opening region is defined in the limiting dam, and the optical functional portion is disposed in the opening region and is configured to convert a color of light entering the optical functional portion; and
an orthographic projection of the dam on the first substrate has a first outer contour, and an orthographic projection of the limiting dam on the first substrate has a second outer contour, wherein the second outer contour is disposed in a region enclosed by the first outer contour.

In some embodiments, a section of the dam perpendicular to the first substrate and perpendicular to an extension direction of the dam includes a first edge facing towards a side of the first substrate and a second edge facing away from the side of the first substrate, wherein
a length of the first edge is greater than a length of the second edge.

In some embodiments, the dam has a first face facing towards the side of the first substrate and a second face facing away from the side of the first substrate, and further has a first outer contour face between the first face and the second face, wherein an angle between the first face and the first outer contour face is an acute angle, and an angle between the second face and the first outer contour face is an obtuse angle.

In some embodiments, the dam has a first face facing towards the side of the first substrate and a second face facing away from the side of the first substrate, wherein
an orthographic projection of the second face on the first substrate is within an orthographic projection of the first face on the first substrate.

In some embodiments, the dam has a first face facing towards the side of the first substrate and a second face facing away from the side of the first substrate, and further has a first outer inner face between the first face and the second face; and
the chip structure further includes a filling portion, wherein at least part of the filling portion is disposed in a region enclosed by the dam,
a part of the filling portion is disposed between the light-emitting units and the first inner contour face and another part of the filling portion is disposed on a side, away from the first substrate, of the light-emitting units, and the filling portion is in contact with the first inner contour face and the light-emitting units.

In some embodiments, the filling portion includes a first filling sub-portion and a second filling sub-portion; wherein
at least part of the first filling sub-portion is disposed between the light-emitting units and the first inner contour face, the second filling sub-portion is disposed on the side, away from the first substrate, of the light-emitting units,
the first filling sub-portion is in contact with the first inner contour face and the second filling sub-portion, and the second filling sub-portion is in contact with the light-emitting units.

In some embodiments, a minimum distance between the filling portion and the first substrate is greater than a distance between the first face and the first substrate; or, a part of the filling portion is disposed on a side, close to the first substrate, of the first face.

In some embodiments, a minimum distance between the filling portion and the first substrate is greater than a distance between the light-emitting units and the first substrate; or, a part of the filling portion is disposed on a side, close to the first substrate, of each of the light-emitting units.

In some embodiments, the limiting dam is in direct contact with the dam, and/or, the limiting dam is in direct contact with each of the light-emitting units.

In some embodiments, the limiting dam has a third face facing towards the side of the first substrate and a fourth face facing away from the side of the first substrate,
a part of the filling portion is disposed on a side, close to the first substrate, of the first face, and the part of the filling portion on the side, close to the first substrate, of the first face includes a first sub-portion covered by the fourth face and a second sub-portion not covered by the fourth face, wherein
the second sub-portion surrounds the first sub-portion.

In some embodiments, the limiting dam has a third face facing towards the side of the first substrate and a fourth face facing away from the side of the first substrate;
wherein the fourth face includes a first region and a second region; wherein the first region is opposite to the first face and extends along the first face, and the second region is opposite to the light-emitting units and extends along a face on a side, close to the first substrate, of each of the light-emitting units; and
a distance between the first region and the first substrate is greater than a distance between the second region and the first substrate; or, a distance between the first region and the first substrate is less than a distance between the second region and the first substrate.

In some embodiments, the fourth face further includes a third region opposite to a part of the filling portion between each of the light-emitting units and the dam, wherein at least one of a distance between the third region and the first substrate, the distance between the first region and the first substrate, or the distance between the second region and the first substrate is different from other distances.

In some embodiments, each of the light-emitting units includes a connection electrode, wherein the connection electrode is disposed on a side, furthest from the first substrate, of the each of the light-emitting units, and
a distance between a face, away from the first substrate, of the connection electrode and the first substrate is greater than a distance between the second face and the first substrate.

In some embodiments, a distance between the second face and the first substrate is greater than a distance between a face, away from the first substrate, of the part of the filling portion between the dam and each of the light-emitting units and the first substrate.

In some embodiments, the first face includes an inner contour edge on a side close to the light-emitting units and an outer contour edge on a side away from the light-emitting units, wherein a distance between the contour edge and the first substrate is greater than a distance between the outer contour edge and the first substrate.

In some embodiments, the light-emitting units includes a first semiconductor layer, wherein a distance between a first pair of feature points furthest from each other along a face on a side, facing towards the first substrate, of the first semiconductor layer is a first distance D1;
a second pair of feature points corresponding to the first pair of feature points are present in an inner region enclosed by an orthographic projection of the first inner contour face on the first substrate, a distance between the second pair of feature points is a second distance D2, and the second pair of feature points indicate a pair of feature points intercepted by a straight line of an orthographic projection of the first pair of feature points on the first substrate in an outer contour of the inner region enclosed by the orthographic projection of the first inner contour face on the first substrate, wherein
the second distance D2 and the first distance D1 meet that a value of (D2-D1) is less than or equal to 30 microns.

In some embodiments, for accommodation spaces enclosed by the dam for accommodating the light-emitting units, areas of various sections of inner of the accommodation spaces in an extension face parallel to the first substrate are increasingly reduced in a direction from the first substrate to the dam.

In some embodiments, a shape of a section of the dam perpendicular to the first substrate and perpendicular to an extension direction of the dam is at least one of an inverted trapezoid, an inverted triangle, or an inverted circular arc relative to the first substrate.

In some embodiments, the limiting dam has a third face facing towards a side of the first substrate and a fourth face facing away from the side of the first substrate, wherein
an orthographic projection of the fourth face on the first substrate is within an orthographic projection of the third face on the first substrate.

In some embodiments, the limiting dam has a third face facing towards a side of the first substrate, a fourth face facing away from the side of the first substrate, and a second outer contour face between the third face and the fourth face, wherein
the second outer contour face is in contact with an external environment.

In some embodiments, each of the color conversion units further includes:
a first encapsulation layer between the first substrate and the limiting dam, wherein a part of the first encapsulation layer is disposed in the opening region, the optical functional portion is disposed between the first encapsulation layer and the first substrate, and
an orthographic projection of the optical functional portion on the first substrate is within an orthographic projection of the first encapsulation layer on the first substrate.

In some embodiments, the first encapsulation layer is in direct contact with the light-emitting units.

In some embodiments, each of the color conversion units further includes a second encapsulation layer between the first substrate and the first encapsulation layer, wherein the optical functional portion is disposed between the first encapsulation layer and the second encapsulation layer, the first encapsulation layer is in direct contact with the second encapsulation layer to seal the optical functional portion; and
each of the color conversion units further includes a light-shielding layer between the first substrate and the limiting dam, wherein an aperture is defined in the light-shielding layer, wherein an orthographic projection of the opening region on the first substrate is overlapped with an orthographic projection of the aperture on the first substrate.

In some embodiments, each of the color conversion units further includes a light-filtering unit between the first substrate and the optical functional portion, wherein an orthographic projection of the light-filtering unit on the first substrate is overlapped with an orthographic projection of a corresponding aperture on the first substrate.

In some embodiments, the light-shielding layer has a fifth face facing towards a side of the first substrate, a sixth face facing away from the first substrate, and a third outer contour face between the fifth face and the sixth face, wherein
the third outer contour face is in contact with an external environment.

In some embodiments, the chip structure further includes: a transparent connection layer, wherein the transparent connection layer is configured to connect the first substrate to the color conversion units.

In some embodiments, an orthographic projection of the transparent connection layer on the first substrate is within the first substrate, and a gap is present between an outer contour of the orthographic projection of the transparent connection layer on the first substrate and an outer contour of the first substrate.

In some embodiments, an outer contour of an orthographic projection of the transparent connection layer on the first substrate and the first outer contour extend in parallel.

In some embodiments, a face, facing towards the first substrate, of the optical functional portion is a cambered face, and
the face, facing towards the first substrate, of the optical functional portion extends along a face on a side, close to the first substrate, of the light-emitting units.

In some embodiments, each of the light-emitting units includes a plurality of light-emitting functional sub-layers and a first semiconductor layer on light-emitting sides of the plurality of light-emitting functional sub-layers, wherein the first semiconductor layer includes a plurality of connection portions in one-to-one correspondence with the plurality of light-emitting functional sub-layers, and an auxiliary portion connected to the plurality of connection portions, wherein the plurality of connection portions are connected to corresponding light-emitting functional sub-layers, at least part of the auxiliary portion is disposed between adjacent connection portions, and the auxiliary portion and the plurality of connection portions are of an integral structure.

In some embodiments, each of the color conversion units further includes a plurality of optical functional portions, and a plurality of opening regions are defined in the limiting dam, wherein
the plurality of optical functional portions are in one-to-one correspondence with the plurality of opening regions, and each of the plurality of optical functional portions is disposed in a corresponding opening region; and the plurality of optical functional portions are in one-to-one correspondence with the plurality of light-emitting functional sub-layers, and a light-emitting side of each of the plurality of light-emitting functional sub-layers faces towards a corresponding optical functional portion.

In some embodiments, each of the color conversion units further includes a light-absorbing layer between the limiting dam and the first substrate, wherein a plurality of apertures in one-to-one correspondence with the plurality of opening regions are defined in the light-absorbing layer, wherein an orthographic projection of each of the plurality of apertures on the first substrate is overlapped with an orthographic projection of a corresponding opening region on the first substrate.

In some embodiments, each of the color conversion units further includes a plurality of light-filtering units, wherein the plurality of light-filtering units are in one-to-one correspondence with the plurality of optical functional portions and the plurality of apertures, wherein
each of the plurality of light-filtering units is disposed between a corresponding optical functional portion and the first substrate, and an orthographic projection of each of the plurality of light-filtering units on the first substrate is overlapped with an orthographic projection of a corresponding aperture on the first substrate.

In some embodiments, the plurality of light-emitting functional sub-layers include a first light-emitting functional sub-layer, a second light-emitting functional sub-layer, and a third light-emitting functional sub-layer; and
the plurality of opening regions include a first opening region, a second opening region, and a third opening region, wherein the first opening region is opposite to the first light-emitting functional sub-layer, the second opening region is opposite to the second light-emitting functional sub-layer, and the third opening region is opposite to the third light-emitting functional sub-layer;
wherein the first opening region and the second opening region are arranged in a line in a first direction, and the second opening region and the third opening region are arranged in a line in a second direction, wherein the first direction is intersected with the second direction.

In some embodiments, each of the color conversion units further includes a first connection electrode and a plurality of second connection electrodes, wherein
the first connection electrode is electrically connected to the first semiconductor layer, and the plurality of second connection electrodes are in one-to-one correspondence with the plurality of light-emitting functional sub-layers, are disposed on a side, facing away from the first semiconductor layer, of corresponding light-emitting functional sub-layers, and are electrically connected to the corresponding light-emitting functional sub-layers.

In some embodiments, the plurality of second connection electrodes are in one-to-one correspondence with the plurality of connection portions, and an orthographic projection of each of the plurality of connection portions on the first substrate is overlapped with an orthographic projection of a corresponding second connection electrode on the first substrate; and
the auxiliary portion includes a first auxiliary portion, a second auxiliary portion, and a third auxiliary portion, wherein an orthographic projection of the first auxiliary portion on the first substrate is overlapped with an orthographic projection of the first connection electrode on the first substrate; a part of the second auxiliary portion is disposed between adjacent connection portions, and another part of the second auxiliary portion is disposed between the first auxiliary portion and each of the plurality of connection portions; and the third auxiliary portion surrounds the first auxiliary portion, the second auxiliary portion, and the plurality of connection portions, wherein
the auxiliary portion and the plurality of connection portions are made of a same material.

In some embodiments, each of the color conversion units further includes a common electrode layer connected to the auxiliary portion in the first semiconductor layer, wherein a side, facing away from the first semiconductor layer, of the common electrode layer is lapped with the first connection electrode; and
each of the plurality of light-emitting functional sub-layers includes a current diffusion layer, a second semiconductor layer, and a light-emitting layer that are laminated in a direction perpendicular to and facing towards the first substrate, wherein a side, facing towards the first substrate, of the light-emitting layer is connected to a corresponding connection portion in the first semiconductor layer, and a side, facing away from the first substrate, of the current diffusion layer is lapped with the plurality of second connection electrodes.

In some embodiments, each of the color conversion units further includes an insulative protecting layer on a side, facing away from the first semiconductor layer of a common electrode layer and the plurality of light-emitting functional sub-layers, wherein orthographic projections of the plurality of light-emitting functional sub-layers and the common electrode layer on the first semiconductor layer are within an orthographic projection of the insulative protecting layer on the first semiconductor layer, the first connection electrode and the plurality of second connection electrodes and disposed on a side, facing away from the first semiconductor layer, of the insulative protecting layer, and
a first connection via corresponding to the first connection electrode and a plurality of second connection vias in one-to-one correspondence with the plurality of second connection electrodes are defined in the insulative protecting layer, wherein the first connection electrode is lapped with the common electrode layer through the first connection via, and each of the plurality of second connection electrodes is lapped with a current diffusion layer in a corresponding light-emitting functional sub-layer through a corresponding second connection via.

In some embodiments, the first semiconductor layer includes a first sub-layer and a second sub-layer that are laminated in a direction perpendicular to and facing towards the first substrate, wherein the first sub-layer is disposed between the second sub-layer and a light-emitting layer and is made of N-type gallium nitride, and the second sub-layer is a gallium nitride buffer layer; and
a second semiconductor layer is made of P-type gallium nitride, and the light-emitting layer is a multi-quantum well layer.

In another aspect, a method for manufacturing a chip structure is provided. The method is applicable to manufacturing the above chip structure, and includes:
forming a plurality of light-emitting units and dams surrounding peripheries of the plurality of light-emitting units on a temporary substrate;
forming a plurality of color conversion units on a side, facing away from the temporary substrate, of the plurality of light-emitting units;
forming a second substrate on a side, facing away from the temporary substrate, of the plurality of color conversion units; and
removing the temporary substrate, and cutting the second substrate to acquire a plurality of chip structures.

In some embodiments, forming the plurality of light-emitting units and the dams surrounding the peripheries of the plurality of light-emitting units on the temporary substrate includes:
providing the plurality of light-emitting units, wherein the plurality of light-emitting units are fixedly arranged on a third substrate;
providing a first adhesive, overlapping the third substrate with the temporary substrate to cause the plurality of light-emitting units to be in contact with the first adhesive between the third substrate and the temporary substrate, and removing the third substrate to form the plurality of light-emitting units on the temporary substrate;
removing the first adhesive between two adjacent light-emitting units; and
forming the dams surrounding the peripheries of the plurality of light-emitting units on the temporary substrate.

In some embodiments, forming the plurality of light-emitting units and the dams surrounding the peripheries of the plurality of light-emitting units on the temporary substrate includes:
forming a plurality of dams on the temporary substrate; and
forming the plurality of light-emitting units, and transferring at least part of the plurality of formed light-emitting units to regions enclosed by corresponding dams by a transferring process.

In some embodiments, prior to forming the plurality of color conversion units on the side, facing away from the temporary substrate, of the plurality of light-emitting units, the method further includes:
filling gaps between the dams and corresponding light-emitting units by a second adhesive to form a plurality of planarization portions on the temporary substrate, wherein each of the plurality of planarization portions includes the dams and the corresponding light-emitting units, and the second adhesive between the dams and the light-emitting units.

In some embodiments, forming the plurality of color conversion units on the side, facing away from the temporary substrate, of the plurality of light-emitting units includes:
forming a limiting dam on a side, facing away from the temporary substrate, of each of the plurality of planarization portions, wherein an opening region is defined in the limiting dam;
forming a first encapsulation layer on a side, facing away from the each of the plurality of planarization portions, of the limiting dam, wherein a part of the first encapsulation layer extends in the opening region;
forming an optical functional portion in the opening region; and
forming a second encapsulation layer on a side, facing away from the temporary substrate, of the optical functional portion, wherein the second encapsulation layer is in contact with the first encapsulation layer to seal the optical functional portion.

In some embodiments, forming the second substrate on the side, facing away from the temporary substrate, of the plurality of color conversion units includes:
forming a transparent connection layer on a side of the second substrate; and
bonding the second substrate to a side, facing away from the temporary substrate, of the plurality of color conversion units by the transparent connection layer.

In some embodiments, upon removing the temporary substrate, the method further includes:
ashing a side, facing towards the plurality of color conversion units, of the second substrate to remove a portion of the transparent connection layer between two adjacent color conversion units.

In another aspect, a display substrate is provided. The display substrate includes a drive backplane and a plurality of chip structures arranged in an array on a side of the drive backplane, wherein each of the plurality of chip structures are the above chip structure.

The technical solutions according to the embodiments of the present disclosure have at least following technical effects.

The chip structure in the embodiments of the present disclosure includes a first substrate, light-emitting units, color conversion units, and a dam layer. The dam layer surrounds the light-emitting units, and a maximum distance between a face, facing away from the color conversion unit, of the dam layer and the first substrate is greater than or equal to a maximum distance between a face, facing away from the first substrate, of a first semiconductor layer in the light-emitting unit. Thus, in the case that the first semiconductor layer generates optical waveguide phenomenon, light laterally transmitted in the first semiconductor layer is blocked by the dam layer upon emitted from any position of the edge. As such, even if the light entering the first semiconductor layer generates the optical waveguide phenomenon, the dam layer is disposed to block the light emitted from the edge of the first semiconductor layer, such that a probability of light leakage of the chip structure is efficiently reduced, and the display effect of the display substrate integrated with the chip structure is great.

### BRIEF DESCRIPTION OF DRAWINGS

For clearer description of the technical solutions according to the embodiments of the present disclosure, the following briefly introduces the accompanying drawings required for describing the embodiments. Apparently, the accompanying drawings in the following description show merely some embodiments of the present disclosure, and persons of ordinary skill in the art may still derive other drawings from these accompanying drawings without creative efforts.
FIG. 1 is a top view of a chip structure according to some embodiments of the present disclosure;
FIG. 2 is a schematic diagram of a film layer structure of the chip structure shown in FIG. 1 at a position A-A';
FIG. 3 is a top view of a first semiconductor layer according to some embodiments of the present disclosure;
FIG. 4 is a schematic effect diagram of optical waveguide phenomenon in a first semiconductor layer according to some embodiments of the present disclosure;
FIG. 5 is a schematic diagram of a film layer structure of the chip structure shown in FIG. 1 at a position A-A';
FIG. 6 is a bottom view of a position relationship of a first semiconductor layer and a dam in a light-emitting chip according to some embodiments of the present disclosure;
FIG. 7 is a schematic diagram of a film layer structure of a chip structure according to some embodiments of the present disclosure;
FIG. 8 is a schematic diagram of a film layer structure of a chip structure according to some embodiments of the present disclosure;
FIG. 9 is a schematic diagram of a film layer structure of a chip structure according to some embodiments of the present disclosure;
FIG. 10 is a schematic diagram of a film layer structure of the chip structure shown in FIG. 1 at a position A-A';
FIG. 11 is a schematic diagram of a film layer structure of the chip structure shown in FIG. 1 at a position A-A';
FIG. 12 is a top view of a chip structure according to some embodiments of the present disclosure;
FIG. 13 is a schematic diagram of a film layer structure of the chip structure shown in FIG. 12 at a position B-B';
FIG. 14 is a schematic diagram of a film layer structure of the chip structure shown in FIG. 12 at a position C-C';
FIG. 15 is a schematic diagram of a film layer structure of a chip structure according to some embodiments of the present disclosure;
FIG. 16 is a schematic diagram of a film layer structure of a chip structure according to some embodiments of the present disclosure;
FIG. 17 is a top view of a light-emitting unit according to some embodiments of the present disclosure;
FIG. 18 is a schematic diagram of a film layer structure of the light-emitting unit shown in FIG. 17 at a position D-D';
FIG. 19 is a top view of a first semiconductor layer according to some embodiments of the present disclosure;
FIG. 20 is a top view of a light-emitting unit according to some embodiments of the present disclosure;
FIG. 21 is a schematic diagram of a film layer structure of the light-emitting unit shown in FIG. 20 at a position E-E';
FIG. 22 is a schematic diagram of formation of a dis-adhesive layer on a temporary substrate according to some embodiments of the present disclosure;
FIG. 23 is a schematic diagram of formation of a plurality of light-emitting units on a third substrate according to some embodiments of the present disclosure;
FIG. 24 is a schematic diagram upon coating of a first adhesive according to some embodiments of the present disclosure;
FIG. 25 is a schematic diagram of formation of a plurality of light-emitting units on a temporary substrate according to some embodiments of the present disclosure;
FIG. 26 is a schematic diagram of removal of a portion between two adjacent light-emitting units in a first adhesive according to some embodiments of the present disclosure;
FIG. 27 is a schematic diagram of formation of dams surrounding peripheries of various light-emitting units on a temporary substrate according to some embodiments of the present disclosure;
FIG. 28 is a schematic diagram of formation of a plurality of planarization portions on a temporary substrate according to some embodiments of the present disclosure;
FIG. 29 is a schematic diagram of formation of color conversion units on a side, facing away from a temporary substrate, of planarization portions according to some embodiments of the present disclosure;
FIG. 30 is a schematic diagram of formation of a second substrate on a side, facing away from a temporary substrate, of a plurality of color conversion units according to some embodiments of the present disclosure;
FIG. 31 is a schematic diagram of removal of a temporary substrate according to some embodiments of the present disclosure;
FIG. 32 is a schematic diagram of formation of a plurality of dams on a side, facing away from a temporary substrate, of a dis-adhesive layer according to some embodiments of the present disclosure;
FIG. 33 is a schematic diagram of transfer of at least part of a plurality of light-emitting units to regions enclosed by corresponding dams according to some embodiments of the present disclosure; and
FIG. 34 is a schematic diagram of filling gaps between various dams and corresponding light-emitting units by a second adhesive according to some embodiments of the present disclosure.

### DETAILED DESCRIPTION

For clearer descriptions of the objects, technical solutions, and advantages of the embodiments of present disclosure, the embodiments of the present disclosure are described in detail hereinafter in combination with the accompanying drawings.

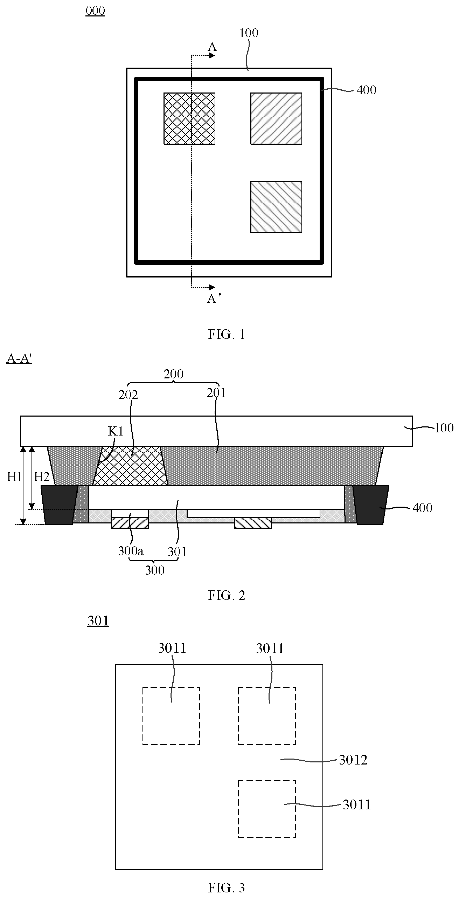

Referring to FIG. 1 and FIG. 2, FIG. 1 is a top view of a chip structure according to some embodiments of the present disclosure. FIG. 2 is a schematic diagram of a film layer structure of the chip structure shown in FIG. 1 at a position A-A'. The chip structure 000 includes a first substrate 100, light-emitting units 300, color conversion units 200.

The color conversion units 200 in the chip structure 000 are disposed between the first substrate 100 and the light-emitting units 300, and light-emitting sides of the light-emitting units 300 face towards the first substrate. In this case, light emitting from the light-emitting units 300 irradiates to the color conversion units 200, and then is emitted upon passing through the color conversion units 200 and the first substrate 100.

Each of the light-emitting units 300 in the chip structure 000 includes light-emitting functional sub-layers 300a, and a first semiconductor layer 301 on light-emitting sides of the light-emitting functional sub-layers 300a. For example, a plurality of light-emitting functional sub-layers 300a are disposed in the light-emitting unit 300, and are jointly connected to a same first semiconductor layer 301. For clearer structure of the first semiconductor layer 301, referring to FIG. 3, FIG. 3 is a top view of a first semiconductor layer according to some embodiments of the present disclosure. The first semiconductor layer 301 includes a plurality of connection portions 3011 in one-to-one correspondence with the plurality of light-emitting functional sub-layers 300a, and an auxiliary portion 3012 connected to the plurality of connection portions 3011.

Each connection portion 3011 in the first semiconductor layer 301 is connected to the corresponding light-emitting functional sub-layer 300a, and an outer boundary of an orthographic projection of each connection portion 3011 on the first substrate 100 is coincident with an outer boundary of an orthographic projection of the corresponding light-emitting functional sub-layer 300a on the first substrate 100.

In the present disclosure, the plurality of connection portions 3011 and the auxiliary portion 3012 in the first semiconductor layer 301 are of an integral structure, and are made of a same material. It is understandable that the plurality of connection portions 3011 and the auxiliary portion 3012 in the first semiconductor layer 301 are arranged in a direction parallel to an extension face of the first substrate 100, the first semiconductor layer 301 is a whole layer planar structure, and portions other than the plurality of connection portions 3011 in the first semiconductor layer 301 are the auxiliary portion 3012. The plurality of connection portions 3011 are connected to each other through the auxiliary portion 3012 in the first semiconductor layer 301.

In the embodiments of the present disclosure, light emitting from the light-emitting functional sub-layers 300a in the light-emitting units 300 passes through the first semiconductor layer 301, and then is emitted upon passing through the color conversion units 200 and the first substrate 100. Due to differences in refractive indexes of mediums of various layers, part of the light irradiated in the first semiconductor layer 301 propagates in an extension direction of the first semiconductor layer 301, such that the light is prone to leaking from a side of the chip structure 000. The part of the light is mixed with light emitted from the color conversion units 200, such that a display color of the chip 000 is abnormal.

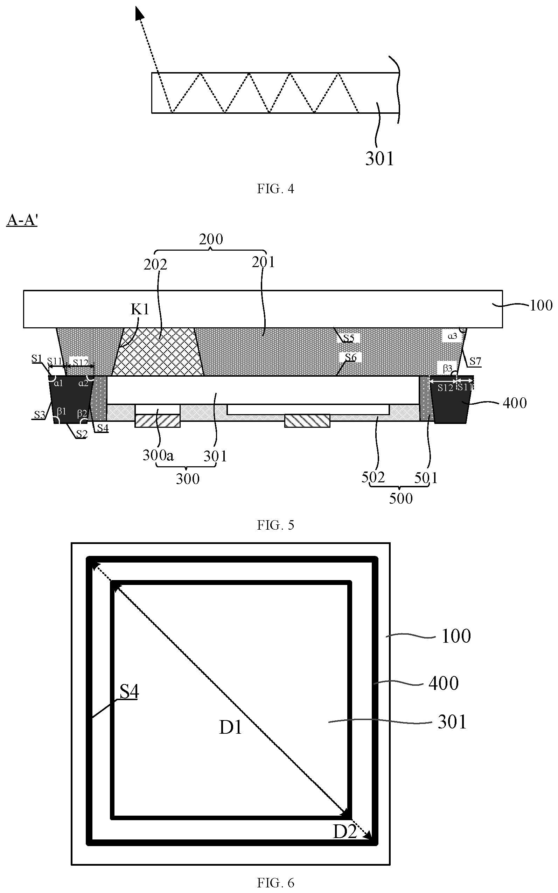

Illustratively, in the case that a plurality of light-emitting functional sub-layers 300a are defined, the first semiconductor layer 301 is a whole layer planar structure. Thus, part of light irradiated in the first semiconductor layer 301 is prone to optical waveguide phenomenon in the first semiconductor layer 301. For example, referring to FIG. 4, FIG. 4 is a schematic effect diagram of optical waveguide phenomenon in a first semiconductor layer according to some embodiments of the present disclosure. Part of light irradiated in the first semiconductor layer 301 undergoes multiple total-reflections back and forth between two opposite planes in the first semiconductor layer 301, undergoes lateral transmission, and is emitted from an edge of the first semiconductor layer 301 eventually. Upon the optical waveguide phenomenon in the first semiconductor layer 301, light emitted from the edge of the first semiconductor layer 301 is not absorbed by a light-shielding layer in the color conversion units 200, such that the chip structure 000 is prone to light leakage.

Thus, as shown in FIG. 2, the chip structure 000 in the present disclosure further includes a dam 400. The dam 400 is disposed on a side, facing away from the first substrate 100, of the color conversion units 200 and surrounds a periphery of each of the light-emitting units 300. Specifically, the dam 400 at least absorbs and/or reflects blue light. For example, the dam 400 absorbs and/or reflects visible light.

For example, the dam 400 is of an integral structure, and are a continuous and end-to-end structure surrounding the peripheries of the light-emitting units 300.

In some embodiments, a maximum distance H1 between a face, facing away from the color conversion units 200, of the dam 400 and the first substrate 100 is greater than or equal to a maximum distance H2 between a face, facing away from the first substrate 100, of the first semiconductor layer 301 and the first substrate 100.

For example, the dam 400 in the chip structure 000 is configured to absorb light laterally transmitted in the first semiconductor layer 301 in the light emitted by the light-emitting functional sub-layers 300a. That is, in the case that the light emitted by the light-emitting functional sub-layers 300a enters the first semiconductor layer 301, and generates the optical waveguide phenomenon in the first semiconductor layer 301, the light laterally transmitted in the first semiconductor layer 301 is absorbed by the dam 400.

Illustratively, the dam 400 in the chip structure 000 is made of at least one of an organic material with a reflective property and an organic material with a light-absorbing property. In the case that the dam 400 is made of an organic material with the light-absorbing property, a material of the dam 400 is a black organic material that absorbs the light laterally transmitted in the first semiconductor layer 301 in the light-emitting unit 300.

For example, the dam 400 is made of a polymer mixed with a light-absorbing material. The polymer is used as a substrate, and the light-absorbing material is mixed in the polymer.

For example, the dam 400 is made of a polymer mixed with a light-absorbing material and scattered particles.

For example, the light-absorbing material is carbon black. The scattered particles are at least one of silicon dioxide particles, titanium dioxide particles, or a polymer with a different refractive index from the dam 400 substrate.

As the dam 400 surrounds the light-emitting unit 300, and the maximum distance H1 between the face, facing away from the color conversion units 200, of the dam 400 and the first substrate 100 is greater than or equal to the maximum distance H2 between the face, facing away from the first substrate 100, of the first semiconductor layer 301 and the first substrate 100, the light laterally transmitted in the first semiconductor layer 301 is blocked by the dam 400 upon emitted from any position of the edge.

In this case, even if the light entering the first semiconductor layer 301 generates the optical waveguide phenomenon, the dam 400 is disposed to block the light emitted from the edge of the first semiconductor layer 301, such that a probability of light leakage of the chip structure 000 is efficiently reduced.

In the case that the dam 400 in the chip structure 000 is made of an organic material with the reflective property, the reflectivity of the dam 400 ranges from 40% to 80%. For example, the reflectivity of the dam 400 is 63%±5%. It should be noted that in the case that the reflectivity of the dam 400 is greater than or equal to 30%, the dam 400 has the reflective property. In the case that the reflectivity of the dam 400 ranges from 40% to 80%, in the case that first light laterally transmitted in the first semiconductor layer 301 is emitted from the edge of the first semiconductor layer 301, the dam 400 is disposed to ensure that much first light is reflected, such that the light leakage of the edge of the chip structure 000 is improved.

In the embodiments of the present disclosure, the color conversion unit 200 in the chip structure 000 includes a limiting dam 201 and an optical functional portion 202. An opening region K1 is defined in the limiting dam 201, and the optical functional portion 202 is disposed in the opening region K1 and is configured to convert a color of light entering the optical functional portion 202.

Illustratively, a plurality of opening regions K1 are defined in the limiting dam 201, and a plurality of optical functional portions 202 are disposed. The plurality of optical functional portions 202 are in one-to-one correspondence with the plurality of opening regions K1, and each optical functional portion 202 is disposed in the corresponding opening region K1. The plurality of optical functional portions 202 are in one-to-one correspondence with the light-emitting functional sub-layers 300a in the light-emitting unit 300, a light-emitting side of each light-emitting functional sub-layer 300a in the light-emitting unit 300 faces towards the corresponding optical functional portion 202, and an orthographic projection of each light-emitting functional sub-layer 300a on the first substrate 100 is overlapped with an orthographic projection of the corresponding optical functional portion 202 on the first substrate 100. For example, the orthographic projection of each light-emitting functional sub-layer 300a in the light-emitting unit 300 on the first substrate 100 is within the orthographic projection of the corresponding optical functional portion 202 on the first substrate 100. As such, light emitted from each light-emitting functional sub-layer 300a in the light-emitting unit 300 is irradiated to the corresponding optical functional portion 202, and the corresponding optical functional portion 202 converts a color of the light, such that the light is emitted upon passing through the first substrate 100.

It should be noted that various light-emitting functional sub-layers 300a in the light-emitting unit 300 may emit light of a same color, types of optical functional portions 202 filled in different opening regions K1 are different, and light emitted by the light-emitting functional sub-layers 300a is converted to light of different colors by different types of optical functional portions 202 upon passing through different opening regions K1.

In the embodiments of the present disclosure, an orthographic projection of the dam 400 in the chip structure 000 on the first substrate 100 has a first outer contour, and an orthographic projection of the limiting dam 201 in the color conversion unit 200 on the first substrate 100 has a second outer contour.

As in the process of manufacturing the chip structure 000 according to the present disclosure, the dams 400 and the light-emitting units 300 are first formed, the color conversion units 200 are then formed on the dams 400 and the light-emitting units 300, and the first substrate 100 is formed on the color conversion units 200, the second outer contour of the limiting dam 201 is within a region enclosed by the first outer contour of the dam 400 to ensure the stability of the chip structure 000. That is, the orthographic projection of the limiting dam 201 on the first substrate 100 is within the region enclosed by the first outer contour of the orthographic projection of the dam 400 on the first substrate 100.

It should be noted that for a high efficiency of manufacturing the chip structure 000, a chip motherboard including a second substrate, a plurality of color conversion units 200, a plurality of light-emitting units 300, and a plurality of dams 400 is first formed, and the substrate in the chip motherboard is cut to acquire a plurality of separate chip structures 000. The second substrate indicates an integral substrate with a great area and is capable of bearing a plurality of color conversion units 200, and the first substrate 100 in a single chip structure 000 belongs to the second substrate.

Illustratively, the method for manufacturing the chip structure 000 includes following processes: S101, forming a plurality of light-emitting units and dams surrounding peripheries of the plurality of light-emitting units on a temporary substrate; S102, forming a plurality of color conversion units on a side, facing away from the temporary substrate, of the plurality of light-emitting units; S103, forming a second substrate on a side, facing away from the temporary substrate, of the plurality of color conversion units; and S104, removing the temporary substrate, and cutting the second substrate to acquire a plurality of chip structures. In some embodiments, for stable formation of the color conversion units on the light-emitting units, gaps between the dams and corresponding light-emitting units are filled by a second adhesive prior to S102 to form a plurality of planarization portions on the temporary substrate, and each of the plurality of planarization portions includes the dams and the corresponding light-emitting units, and the second adhesive between the dams and the light-emitting units, such that the color conversion units are stably formed on the side, facing away from the temporary substrate, of each of the plurality of planarization portions. Detailed descriptions of processes in the method for manufacturing the chip structure 000 are not limited here and are described in following embodiments. It should be noted that a flatness of the side, facing away from the temporary substrate, of the planarization portion is higher than a flatness of the side not filled with the second adhesive. That is, the side, facing away from the temporary substrate, of the planarization portion is flatter than an overall counter of the light-emitting units and the dams prior to filling of the second adhesive. Specifically, the second adhesive fills the gap between the dam and the light-emitting unit. Thus, the present disclosure does not limit that the side, facing away from the temporary substrate, of the planarization portion extends parallel to the temporary substrate.

In the embodiments of the present disclosure, as shown in FIG. 2, as the dam 400 in the chip structure 000 is made of an organic material and formed on the temporary substrate, and have a thickness required for surrounding the light-emitting units 200 (for example, the thickness of the dam 400 ranges from 4 microns to 15 microns), upon formation of the dam 400 by exposing and developing processes, a section of the dam 400 perpendicular to the first substrate 100 and perpendicular to an extension direction of the dam 400 (for example, the section corresponding to the profile A-A' ) is a trapezoid with respect to the first substrate 100.

For example, the section of the dam 400 perpendicular to the first substrate 100 and perpendicular to the extension direction of the dam 400 includes a first edge facing towards a side of the first substrate 101 and a second edge facing away from the side of the first substrate 101. A length of the first edge is greater than a length of the second edge.

In the present disclosure, referring to FIG. 5, FIG. 5 is a schematic diagram of a film layer structure of the chip structure shown in FIG. 1 at a position A-A'. The dam 400 in the chip structure 000 has a first face S1 facing towards the side of the first substrate 100 and a second face S2 facing away from the side of the first substrate 100. The dam 400 further has a first outer contour face S3 and a first inner contour face S4 between the first face S1 and the second face S2. The first outer contour face S3 is a face surrounding the dam 400. That is, the first outer contour face S3 is an outer side face of the dam 400. The first inner contour face S4 is a face opposite to the first outer contour face S3 of the dam 400. That is, the first inner contour face S4 is an inner side face of the dam 400.

In the case that the section of the dam 400 perpendicular to the first substrate 100 and perpendicular to the extension direction of the dam 400 is a trapezoid with respect to the first substrate 100, an angle α1 between the first face S1 and the first outer contour face S3 of the dam 400 is an acute angle, an angle α2 between the first face S1 and the first inner contour face S4 of the dam 400 is an acute angle, an angle β1 between the second face S2 and the first outer contour face S3 of the dam 400 is an obtuse angle, and an angle β2 between the second face S2 and the first inner contour face S4 of the dam 400 is an obtuse angle. In addition, an orthographic projection of the second face S2 of the dam 400 on the first substrate 100 is within an orthographic projection of the first face S1 of the dam 400 on the first substrate 100.

In the embodiments of the present disclosure, referring to FIG. 6, FIG. 6 is a bottom view of a position relationship of a first semiconductor layer and a dam in a light-emitting chip according to some embodiments of the present disclosure. A distance between a first pair of feature points furthest from each other in a face on a side, facing towards the first substrate 100, of the first semiconductor layer 301 in the light-emitting unit 300 is a first distance D1, a second pair of feature points corresponding to the first pair of feature points are present in an inner region enclosed by an orthographic projection of the first inner contour face S4 in the dam 400 on the first substrate 100, a distance between the second pair of feature points is a second distance D2, and the second distance D2 and the first distance D1 meet that a value of (D2-D1) is less than or equal to 30 microns. The second pair of feature points indicate a pair of feature points intercepted by a straight line of an orthographic projection of the first pair of feature points on the first substrate 100 in an outer contour of the inner region enclosed by the orthographic projection of the first inner contour face S4 on the first substrate 100. The outer contour of the inner region enclosed by the orthographic projection of the first inner contour face S4 on the first substrate 100 indicates an outer contour of a portion, not including the orthographic projection of the first inner contour face S4 on the first substrate 100, of the inner region enclosed by the orthographic projection of the first inner contour face S4 on the first substrate 100.

Specifically, in the process of manufacturing the chip structure 000, for S301 to S308 in following embodiments, the dam 400 is affixed on the temporary substrate prior to the light-emitting unit 300, such that transfer precision of the light-emitting unit 300 is improved in subsequent process of transferring the light-emitting unit to the temporary substrate, and an impact on the luminous effect of chip structure 000 due to alignment deviation between the optical functional portion 202 and the light-emitting functional sub-layer 300a is avoided in subsequent process of manufacturing the color conversion unit 200.

For different requirements on precision, for example, the value of (D2-D1) is less than or equal to 10 microns, the value of (D2-D1) is less than or equal to 5 microns, the value of (D2-D1) is less than or equal to 3 microns, the value of (D2-D1) is less than or equal to 2 microns, the value of (D2-D1) is less than or equal to 1 microns, the value of (D2-D1) is less than or equal to 0.8 microns, and the value of (D2-D1) is less than or equal to 0.5 microns.

It should be noted that in the case that the section of the dam 400 perpendicular to the first substrate 100 and perpendicular to the extension direction of the dam 400 is a trapezoid with respect to the first substrate 100, for accommodation spaces enclosed by the dam 400 for accommodating the light-emitting units 300, areas of various sections of inner of the accommodation spaces in an extension face parallel to the first substrate 100 are increasingly increased from up to bottom (that is, in a direction from the first substrate 100 to the dam 400).

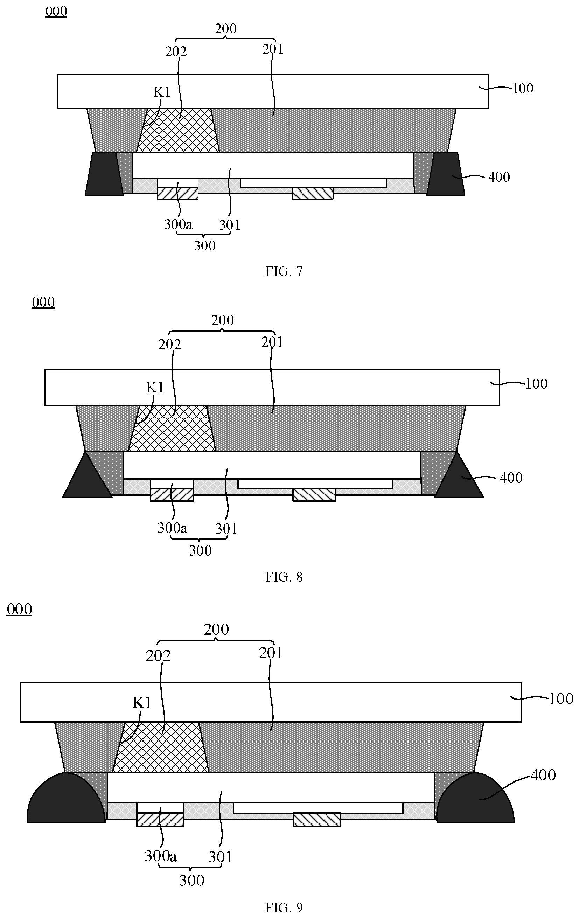

In some embodiments, as shown in FIG. 7, FIG. 7 is a schematic diagram of a film layer structure of a chip structure according to some embodiments of the present disclosure. For accommodation spaces enclosed by the dam 400 for accommodating the light-emitting units 300, areas of various sections of inner of the accommodation spaces in an extension face parallel to the first substrate 100 are increasingly reduced in a direction from the first substrate 100 to the dam 400.

Illustratively, a shape of a section of the dam 400 perpendicular to the first substrate 100 and perpendicular to an extension direction of the dam 400 is at least one of an inverted trapezoid, an inverted triangle, or an inverted circular arc relative to the first substrate 100. Specifically, referring to FIG. 7, the inverted trapezoid indicates that a shorter lower edge of the trapezoid is closer to the first substrate 100 than a longer upper bottom. Referring to FIG. 8, FIG. 8 is a schematic diagram of a film layer structure of a chip structure according to some embodiments of the present disclosure. The inverted triangle indicates that a top angle of the triangle is closer to the first substrate 100 than the base edge. Referring to FIG. 9, FIG. 9 is a schematic diagram of a film layer structure of a chip structure according to some embodiments of the present disclosure. The inverted circular arc indicates that a circular arc edge of the circular arc is closer to the first substrate 100 than the base edge.

As such, the dam 400 provides an accommodation space with "a wider top and a narrower bottom" to facilitate efficient falling in the transferring process. It is understandable, the light-emitting units 300 fall in the bottom of the accommodation space provided by the dam 400 even if there is alignment deviation in the transferring process, such that the transfer position of the light-emitting unit is accurately controlled.

In the embodiments of the present disclosure, as shown in FIG. 5, the chip structure 000 further includes a filling portion 500. At least part of the filling portion 500 is disposed in a region enclosed by the dam 400. A part of the filling portion 500 is disposed between the light-emitting units 300 and a first inner contour face S4 of the dam 400, another part of the filling portion 500 is disposed on a side, away from the first substrate 100, of the light-emitting units 300, and the filling portion is in contact with the first inner contour face S4 of the dam 400 and the light-emitting units 400.

Illustratively, the filling portion 500 is of an integral structure. That is, the filling portion 500 is continuous in any position thereof without an obvious material boundary.

Illustratively, the materials of the filling portion 500 in any position thereof are the same.

Illustratively, the filling portion 500 has a light-absorbing property, for example, mixing a black dye in the substrate material. For example, in the case that a plurality of optical functional portions 201 are disposed, the fill portion 500 is disposed in this way to reduce or avoid propagation of light in the fill portion 500 and reduce or avoid color crosstalk.

Illustratively, the filling portion 500 has a reflective property, for example, mixing an inorganic material with the reflective property in the substrate material. For example, in the case that one optical functional portion 201 is disposed, the fill portion 500 is disposed in this way to improve the luminous efficiency of the chip structure 000.

Illustratively, the filling portion 500 in the chip structure 000 includes a first filling sub-portion 501 and a second filling sub-portion 502. At least part of the first filling sub-portion 501 is disposed between the light-emitting units 300 and the first inner contour face S4 of the dam 400, the first filling sub-portion 501 is in contact with the first inner contour face S4 of the dam 400; and the second filling sub-portion 502 is disposed on the side, away from the first substrate 100, of the light-emitting units 500, and the second filling sub-portion 502 is in contact with the light-emitting units 400. A side, facing away from the first inner contour face S4, of the first filling sub-portion 501 is in contact with the second filling sub-portion 502.

It should be noted that the second filling sub-portion 502 is disposed on the side, away from the first substrate 100, of the first semiconductor layer 301 in the light-emitting unit 300, and in contact with the side, away from the first substrate 100, of the first semiconductor layer 301 and the light-emitting functional sub-layers 300a in the light-emitting unit 300.

In some embodiments, in the process of manufacturing the chip structure 000, the light-emitting units 300 are affixed on the temporary substrate by a first adhesive, a cured product of the first adhesive is remained in the light-emitting units 300 upon subsequent removal of the temporary substrate, and thus the second filling sub-portion 502 in the filling portion500 is the cured product of the first adhesive. For example, a material of the first adhesive is an organic material with an adhesive property, for example, an epoxy resin organic adhesive material.

In the process of manufacturing the chip structure 000, the gap between the light-emitting unit 300 and the dam 400 is filled by the second adhesive, and thus a portion acquired by curing the second adhesive is the first filling sub-portion 501 in the filling portion500. That is, the first filling sub-portion 501 in the filling portion 500 is the cured product of the second adhesive in the gap between the light-emitting unit 300 and the dam 400. For example, a material of the second adhesive is an organic resin material that is transparent to visible light. Thus, a material of the first filling sub-portion 501 is also an organic resin material that is transparent to visible light.

In the manufacturing process, the materials of the first adhesive and the second adhesive are different, and thus the materials of the first filling sub-portion 501 and the second filling sub-portion 502 are different.

For example, the materials of the first filling sub-portion 501 and the second filling sub-portion 502 are the same.

Illustratively, at least one of the first filling sub-portion 501 and the second filling sub-portion 502 has the light-absorbing property, for example, mixing a black dye in the substrate material. For example, in the case that in the case that a plurality of optical functional portions 201 are disposed, the first filling sub-portion 501 and the second filling sub-portion 502 are disposed in this way to reduce or avoid propagation of light in the first filling sub-portion 501 and the second filling sub-portion 502 and reduce or avoid color crosstalk.

Illustratively, at least one of the first filling sub-portion 501 and the second filling sub-portion 502 has a reflective property, for example, mixing an inorganic material with the reflective property in the substrate material. For example, in the case that one optical functional portion 201 is disposed, the first filling sub-portion 501 and the second filling sub-portion 502 are disposed in this way to improve the luminous efficiency of the chip structure 000.

In the embodiments of the present disclosure, as shown in FIG. 5, the limiting dam 201 in the color conversion unit 200 has a third face S5 facing towards a side of the first substrate 100, a fourth face S6 facing away from the side of the first substrate 100, and a second outer contour face S7 between the third face S5 and the fourth face S6. The second outer contour face S7 is a face entirely surrounding a periphery of the limiting dam 201. That is, the second outer contour face S7 is an outer side face of the limiting dam 201.

The limiting dam 201 in the color conversion unit 200 includes an organic material and is formed on the first face S1 of the dam but not on the first substrate 100, and a thickness of the limiting dam 201 meets a requirement on a thickness of the optical functional portion 202. For example, the thickness of the limiting dam 201 ranges from 4 microns to 15 microns. Thus, upon formation of the limiting dam 201 by exposing and developing processes, a width of the third face S5 of the limiting dam 201 is greater than a width of the fourth face S6. Illustratively, an orthographic projection of the fourth face S6 of the limiting dam 201 on the first substrate 100 is within an orthographic projection of the third face S5 of the limiting dam 201 on the first substrate 100. An angle α3 between the third face S5 of the limiting dam 201 and the second outer contour face S7 of the dam 400 is an acute angle, an angle α4 between the fourth face S6 of the limiting dam 201 and the second outer contour face S7 is an obtuse angle.

In the embodiments of the present disclosure, position relationships of the filling portion 500 in the chip structure 000 between the light-emitting unit 300 and the dam 400 are several cases, and the embodiments of the present disclosure are illustrated by taking following four possible cases as an example.

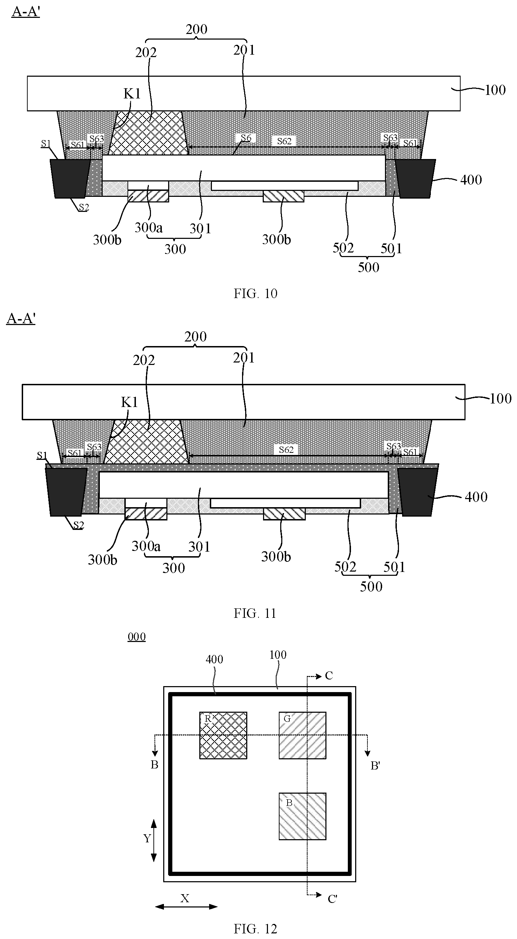

In a first possible case, as shown in FIG. 10, FIG. 10 is a schematic diagram of a film layer structure of the chip structure shown in FIG. 1 at a position A-A'. A minimum distance between the filling portion 500 in the chip structure 000 and the first substrate 100 is greater than a distance between the first face S1 of the dam 400 and the first substrate 100. In this case, the dam 400 in the chip structure 000 is in direct contact with the limiting dam 201 in the color conversion unit 200.

Illustratively, in the case that the gap between the light-emitting unit 300 and the dam 400 is filled by the second adhesive in the process of manufacturing the chip structure 000, the second adhesive is printed at least in the gap between the light-emitting unit 300 and the dam 400 by an inkjet printing process, rather than on the first face S1 of the dam 400. As such, in the manufactured chip structure 400, the minimum distance between the filling portion 500 and the first substrate 100 is greater than the distance between the first face S1 of the dam 400 and the first substrate 100. In some embodiments, the minimum distance between the filling portion 500 and the first substrate 100 is equal to the distance between the first face S1 of the dam 400 and the first substrate 100.

As the second adhesive used in the process of manufacturing the chip structure 000 forms the first filling sub-portion 501 in the filling portion 500 upon curing, the first filling sub-portion 501 in the filling portion 500 is not disposed on the first face S1 of the dam 400, such that the first face S1 of the dam 400 is in direct contact with a side, facing away from the first substrate 100, of the limiting dam 201 in the color conversion unit 200.

In a second possible case, as shown in FIG. 10, a minimum distance between the filling portion 500 in the chip structure 000 and the first substrate 100 is greater than a distance between the light-emitting units 300 and the first substrate 100. In this case, the light-emitting units 300 in the chip structure 000 are in direct contact with the limiting dam 201 in the color conversion unit 200. The distance between the light-emitting units 300 and the first substrate 100 is a distance between a side, facing towards the first substrate 100, of the first semiconductor layer 301 in the light-emitting unit 300 and the first substrate 100. Thus, the limiting dam 201 in the color conversion unit 200 is in direct contact with the first semiconductor layer 301 in the light-emitting unit 300. In this case, the distance between the first semiconductor layer 301 and the optical functional portion 202 is reduced as much as possible, such that much light emitted by the light-emitting functional sub-layer 300a enters the corresponding optical functional portion 202, and the luminous efficiency of the chip structure 000 is improved. Furthermore, in the case that a plurality of light-emitting functional sub-layers 300a are disposed, the distance between the light-emitting functional sub-layer 300a and the corresponding optical functional portion 202 is small, such that the light from the light-emitting functional sub-layer 300a to other optical functional portions 202 is reduced or avoided, and the color crosstalk in the chip structure 000 is reduced or avoided.

Illustratively, in the case that the gap between the light-emitting unit 300 and the dam 400 is filled by the second adhesive in the process of manufacturing the chip structure 000, the second adhesive is printed at least in the gap between the light-emitting unit 300 and the dam 400 by an inkjet printing process, rather than on the side, facing towards the first substrate 100, of the first semiconductor layer 301 in the light-emitting unit 300. As such, in the manufactured chip structure 400, the minimum distance between the filling portion 500 and the first substrate 100 is greater than the distance between the first semiconductor layer 301 in the light-emitting unit 300 and the first substrate 100. In some embodiments, the minimum distance between the filling portion 500 and the first substrate 100 is equal to the distance between the first semiconductor layer 301 and the first substrate 100.

As the second adhesive used in the process of manufacturing the chip structure 000 forms the first filling sub-portion 501 in the filling portion 500 upon curing, the first filling sub-portion 501 in the filling portion 500 is not disposed on the side, facing towards the first substrate 100, of the first semiconductor layer 301 in the light-emitting unit 300, such that the side, facing towards the first substrate 100, of the first semiconductor layer 301 is in direct contact with a side, facing away from the first substrate 100, of the limiting dam 201 in the color conversion unit 200.

In a third possible case, as shown in FIG. 11, FIG. 11 is a schematic diagram of a film layer structure of the chip structure shown in FIG. 1 at a position A-A'. A part of the filling portion 500 in the chip structure 000 is disposed on a side, close to the first substrate 100, of the first face S1 of the dam 400. In this case, a minimum distance between the filling portion 500 in the chip structure 000 and the first substrate 100 is less than a distance between the first face S1 of the dam 400 and the first substrate 100.

Illustratively, in the case that the gap between the light-emitting unit 300 and the dam 400 is filled by the second adhesive in the process of manufacturing the chip structure 000, the second adhesive is printed at least in the gap between the light-emitting unit 300 and the dam 400 by an inkjet printing process. For example, the second adhesive is remained on the first face S1 of the dam 400. As the second adhesive used in the process of manufacturing the chip structure 000 forms the first filling sub-portion 501 in the filling portion 500 upon curing, a part of the first filling sub-portion 501 in the filling portion 500 is disposed on the first face S1 of the dam 400.

For example, the second adhesive is printed on the first face S1 of the dam 400, or, is overflowed on the first face S1 of the dam 400 upon being printed in the gap between the light-emitting unit 300 and the dam 400. Thus, a part of the first filling sub-portion 501 in the filling portion 500 is disposed on the first face S1 of the dam 400. Referring to FIG. 11, the first filling sub-portion 501 includes a part on the first face S1 of the dam 400, and a part on a face on a side, facing towards the first substrate 100, of the first semiconductor layer 301. Transition between the two parts is smooth, and thus morphology complexity of the side of the color conversion unit 200 away from the first substrate 100 is reduced, and poor emission of the color conversion unit 200 due to interference of the morphology is avoided. In some embodiments, the part of the first filling sub-portion 501 on the first face S1 of the dam 400 and the part of the first filling sub-portion 501 on the side, facing towards the first substrate 100, of the first semiconductor layer 301 are disposed in a same plane or are approximately disposed in a same plane.

For example, the second adhesive is printed on the first face S1 of the dam 400 due to limitation of print precision. For example, in the process of printing the second adhesive, a part of the second adhesive is bonded on the first face S1 and then is cured. Furthermore, a part of the second adhesive falls in a region between dam 400 of adjacent chip structures 000 and then is cured. The second adhesive falling in the region between dam 400 of adjacent chip structures 000 and then being cured is removed by a subsequent ashing process, such that cutting of the chip motherboard is not affected. Thus, an impact on the manufacturing of the chip structure 000 by the print precision of the second adhesive is less due to the dam 400. In some embodiments, for convenient entering of the second adhesive in the gap between the light-emitting unit 300 and the dam 400, the first face S1 includes an inner counter edge close to the side of the light-emitting unit 300 and an outer counter edge away from the light-emitting unit 300, and a distance between the inner counter edge close to the side of the light-emitting unit 300 and the first substrate 100 is greater than a distance between the outer counter edge away from the light-emitting unit 300 and the first substrate, such that the second adhesive falling on the first face S1 in printing process falls in the gap between the light-emitting unit 300 and the dam 400. In some embodiments, the first face S1 of the dam 400 includes at least one of a bevel face, a stepped face, or a cambered face that are inclined towards the light-emitting unit 300. For the structure, the dam 400 is manufactured by a single process using a semi-transmission mask process.

In a fourth possible case, as shown in FIG. 11, a part of the filling portion 500 in the chip structure 000 is disposed on a side, close to the first substrate 100, of the light-emitting unit 300. The part of the filling portion 500 in the chip structure 000 is disposed on a side, close to the first substrate 100, of the first semiconductor layer 301 in the light-emitting unit 300. In this case, a minimum distance between the filling portion 500 in the chip structure 000 and the first substrate 100 is less than a distance between the first semiconductor layer 301 and the first substrate 100.

Illustratively, in the case that the gap between the light-emitting unit 300 and the dam 400 is filled by the second adhesive in the process of manufacturing the chip structure 000, the second adhesive is printed at least in the gap between the light-emitting unit 300 and the dam 400 and the side, close to the first substrate 100, of the first semiconductor layer 301 by an inkjet printing process. Alternatively, the second adhesive is overflowed on the side, close to the first substrate 100, of the first semiconductor layer 301 upon being printed in the gap between the light-emitting unit 300 and the dam 400 by an inkjet printing process. As the second adhesive used in the process of manufacturing the chip structure 000 forms the first filling sub-portion 501 in the filling portion 500 upon curing, a part of the first filling sub-portion 501 in the filling portion 500 is disposed on the side, close to the first substrate 100, of the first semiconductor layer 301.

Specifically, a thickness of the filling portion 500 on the side, close to the first substrate 100, of the light-emitting unit 300 is less than 1 micron. In some embodiments, the thickness is less than 0.9 microns, for example, less than 0.8 microns, or less than 0.5 microns. For example, 0.9 microns, 0.8 microns, 0.7 microns, 0.6 microns, 0.5 microns, 0.4 microns, 0.3 microns, 0.2 microns, 0.1 micron, and even 0.1 micron below. For example, in the case that the transition between the part on the first face S1 of the dam 400 and the part on the face on the side, facing towards the first substrate 100, of the first semiconductor layer 301 in the first filling sub-portion 501 is smooth, the thickness of the filling portion 500 on the side, close to the first substrate 100, of the light-emitting unit 300 is less as much as possible. In this case, the distance between the first semiconductor layer 301 and the optical functional portion 202 is reduced as much as possible, such that much light emitted by the light-emitting functional sub-layer 300a enters the corresponding optical functional portion 202, and the luminous efficiency of the chip structure 000 is improved.

It is understandable that due to the dam 400, the thickness of the filling portion 500 on the side, close to the first substrate 100, of the light-emitting unit 300 is controlled more accurately by setting a difference between the thickness of the dam 400 and the thickness of the light-emitting unit 300.

It should be noted that the above embodiments are illustrated by taking four possible cases as an example. Illustratively, in the process of filling the gap between the light-emitting unit 300 and the dam 400 by the second adhesive, the second adhesive is only printed in the gap between the light-emitting unit 300 and the dam 400 by an inkjet printing process, and is not printed outside the gap. As such, as shown in FIG. 10, the limiting dam 201 in the color conversion unit 200 is in direct contact with the dam 400 and the light-emitting unit 300. In some embodiments, in the process of filling the gap between the light-emitting unit 300 and the dam 400 by the second adhesive, the second adhesive is printed in the gap between the light-emitting unit 300 and the dam 400 by an inkjet printing process, and is also printed on the first face S1 of the dam 400 and the side, close to the first substrate 100, of the light-emitting unit 300. As such, as shown in FIG. 11, a part of the filling portion 500 in the chip structure is disposed on the first face S1 of the dam 400 and the side, close to the first substrate 100, of the light-emitting unit 300.

It should be further noted that in some embodiments, a part of the filling portion 500 in the chip structure is only disposed on the first face S1 of the dam 400, and is not disposed on the side, close to the first substrate 100, of the light-emitting unit 300; or, a part of the filling portion 500 in the chip structure is only disposed on the side, close to the first substrate 100, of the light-emitting unit 300, and is not disposed on the first face S1 of the dam 400.

In actual implementations, a second adhesive with high fluidity is used, such that the second adhesive fully enters the gap between the light-emitting unit 300 and the dam 400, and is not easy to be remained on the first face S1 of the dam 400 and the face on the side, close to the first substrate 100, of the light-emitting unit 300.

In the present disclosure, the limiting dam 201 is made of at least one of an organic material with a reflective property and an organic material with a light-absorbing property. In this case, the distance between the first face S1 of the dam 400 in the chip structure 000 and the first substrate 100 is less than or equal to the distance between the first semiconductor layer 301 in the light-emitting unit 300 and the first substrate 100, or is greater than the distance between the first semiconductor layer 301 in the light-emitting unit 300 and the first substrate 100. For example, the limiting dam 201 and the dam 400 are made of a same material.

Illustratively, in the case that the distance between the first face S1 of the dam 400 in the chip structure 000 and the first substrate 100 is less than or equal to the distance between the first semiconductor layer 301 in the light-emitting unit 300 and the first substrate 100, as shown in FIG. 11, the light laterally transmitted in the first semiconductor layer 301 is blocked by the dam 400 upon the optical waveguide phenomenon in the first semiconductor layer 301. In the case that the distance between the first face S1 of the dam 400 in the chip structure 000 and the first substrate 100 is greater than the distance between the first semiconductor layer 301 in the light-emitting unit 300 and the first substrate 100, as shown in FIG. 10, a part of the light laterally transmitted in the first semiconductor layer 301 is blocked by the dam 400 upon the optical waveguide phenomenon in the first semiconductor layer 301, and another part of the light laterally transmitted in the first semiconductor layer 301 is blocked by the limiting dam 201 as the dam 400 and the limiting dam 201 are laminated.

In the embodiments of the present disclosure, as shown in FIG. 5 to FIG. 7, the first face S1 of the dam 200 includes a region S11 overlapped by a fourth face S6 of the limiting dam 201 and a region S12 not overlapped by the fourth face S6 of the limiting dam 201, and the region S12, not overlapped by the fourth face S6, in the first face S1 of the dam 200 surrounds the region S11, overlapped by the fourth face S6, in the first face S1 of the dam 200.

In some embodiments, referring to FIG. 5, an orthographic projection of the second face S2 of the dam 400 on the first substrate 100 is within an orthographic projection of the first face S1 of the dam 400 on the first substrate 100. Thus, a first outer counter of an orthographic projection of the dam 400 on the first substrate 100 is an outer boundary of the orthographic projection of the first face S1 of the dam 400 on the first substrate 100. Likewise, as an orthographic projection of the fourth face S6 of the limiting dam 201 on the first substrate 100 is within an orthographic projection of the third face S5 of the limiting dam 201 on the first substrate 100, a second outer counter of an orthographic projection of the limiting dam 201 on the first substrate 100 is an outer boundary of the orthographic projection of the third face S5 of the limiting dam 201 on the first substrate 100. Furthermore, the second outer counter of the orthographic projection of the limiting dam 201 on the first substrate 100 is within a region enclosed by the first outer counter of the orthographic projection of the dam 400 on the first substrate 100, and the fourth face S6 of the limiting dam 201 faces towards the second face S2 of the dam 400.

In some embodiments, referring to FIG. 11, in the case that a part of the filling portion 500 in the chip structure 000 is disposed on a side, close to the first substrate 100, of the first face S1, the part of the filling portion 500 on the first face S1 of the dam 400 includes a first sub-portion covered by the fourth face S6 of the limiting dam 201 and a second sub-portion not covered by the fourth face S6 of the limiting dam 201. The second sub-portion surrounds the first sub-portion.

In the embodiments of the present disclosure, as shown in FIG. 10 and FIG. 11, the fourth face S6 of the limiting dam 201 includes a first region S61 and a second region S62. The first region S61 in the fourth face S6 of the limiting dam 201 is a region opposite to the first face S1 of the dam 400 and extending along the first face S1 of the dam 400. The second region S62 in the fourth face S6 of the limiting dam 201 is a region opposite to the light-emitting unit 300 and extending along a face, close to the first substrate 100, of the light-emitting unit 300. That is, an orthographic projection of the first region S61 in the fourth face S6 of the limiting dam 201 on the first substrate 100 is within the orthographic projection of the dam 400 on the first substrate 100, and an orthographic projection of the second region S62 in the fourth face S6 of the limiting dam 201 on the first substrate 100 is within the orthographic projection of the light-emitting unit 300 on the first substrate 100.

In some embodiments, as shown in FIG. 10, a distance between the first region S61 in the fourth face S6 of the limiting dam 201 and the first substrate 100 is greater than a distance between the second region S62 in the fourth face S6 of the limiting dam 201 and the first substrate 100. In this case, a distance between the first face S1 of the dam 400 and the first substrate 100 is greater than a distance between a side, facing towards the first substrate 100, of the first semiconductor layer 301 in the light-emitting unit 300 and the first substrate 100. As such, a part of the light laterally transmitted in the first semiconductor layer 301 is blocked by the dam 400 upon the optical waveguide phenomenon in the first semiconductor layer 301, and another part of the light is blocked by the limiting dam 201.

In some embodiments, a distance between the first region S61 in the fourth face S6 of the limiting dam 201 and the first substrate 100 is less than a distance between the second region S62 in the fourth face S6 of the limiting dam 201 and the first substrate 100. In this case, a distance between the first face S1 of the dam 400 and the first substrate 100 is less than a distance between a side, facing towards the first substrate 100, of the first semiconductor layer 301 in the light-emitting unit 300 and the first substrate 100. As such, the light laterally transmitted in the first semiconductor layer 301 is all blocked by the dam 400 upon the optical waveguide phenomenon in the first semiconductor layer 301.

In some embodiments, a distance between the first region S61 in the fourth face S6 of the limiting dam 201 and the first substrate 100 is equal to a distance between the second region S62 in the fourth face S6 of the limiting dam 201 and the first substrate 100. That is, the first region S61 is flush with the second region S62 in the fourth face S6 of the limiting dam 201. In this case, the first face S1 of the dam 400 is flush with the side, facing towards the first substrate 100, of the first semiconductor layer 301 in the light-emitting unit 300. The light laterally transmitted in the first semiconductor layer 301 is all blocked by the dam 400 upon the optical waveguide phenomenon in the first semiconductor layer 301.

In the embodiments of the present disclosure, the fourth face S6 of the limiting dam 201 further includes a third region S63 opposite to a portion, between the light-emitting unit 300 and the dam 400, of the filling portion 500. The third region S63 in the fourth face S6 of the limiting dam 201 is disposed between the first region S61 and the second region S62. That is, an orthographic projection of the third region S62 in the fourth face S6 of the limiting dam 201 on the first substrate 100 is within an orthographic projection of the portion, between the light-emitting unit 300 and the dam 400, of the filling portion 500 on the first substrate 100.

For example, at least one of a distance between the third region S63 in the fourth face S6 of the limiting dam 201 and the first substrate 100, the distance between the first region S61 in the fourth face S6 of the limiting dam 201 and the first substrate 100, or the distance between the second region S62 in the fourth face S6 of the limiting dam 201 and the first substrate 100 is different from other distances, or the three distances are different from each other.

For example, the distances between the first region S61, the second region S62 and the third region S63 and the first substrate 100 are conformal with a face contacted with the first region S61, the second region S62 and the third region S63 due to processes sequence of manufacturing the chip structure 000. That is, the filling portion 500 is manufactured in the gap (or filled in other positions described in the present disclosure) between the light-emitting unit 300 and the dam 400 on the temporary substrate, and then the limiting dam 201 is manufactured on a side, away from the temporary substrate, of the light-emitting unit 300, the dam 400, and the filling portion 500, such that a "bottom-up" manufacturing process of the chip structure 000 is achieved. In some embodiment, as shown in FIG. 10, in the case that the filling portion 500 is not disposed on the first face S1 of the dam 400 and the side, facing towards the first substrate 100, of the light-emitting unit 300, the first region S61 in the fourth face S6 of the limiting dam 201 is in direct contact with the first face S1 of the dam 400, and a distance between the first region S61 in the fourth face S6 of the limiting dam 201 and the first substrate 100 is a distance between the first face S1 of the dam 400 and the first substrate 100; the second region S62 in the fourth face S6 of the limiting dam 201 is in direct contact with the side, facing towards the first substrate 100, of the light-emitting unit 300, and a distance between the second region S62 in the fourth face S6 of the limiting dam 201 and the first substrate 100 is a distance between the side, facing towards the first substrate 100, of the light-emitting unit 300 and the first substrate 100; and the third region S63 in the fourth face S6 of the limiting dam 201 is in direct contact with a part of the filling portion 500, the part of the filling portion 500 is disposed between the light-emitting unit 300 and the dam 400, and a distance between the third region S63 in the fourth face S6 of the limiting dam 201 and the first substrate 100 is a distance between a side, facing towards the first substrate 100, of the part of the filling portion 500 between the light-emitting unit 300 and the dam 400 and the first substrate 100.

In some embodiments, as shown in FIG. 11, in the case that a part of the filling portion 500 is disposed on the first face S1 of the dam 400 and the side, facing towards the first substrate 100, of the light-emitting unit 300, the filling portion 500 is disposed in the gap between the light-emitting unit 300 and the dam 400 and covers the light-emitting unit 300 and the dam 400. In this case, the limiting dam 201 is disposed a side, facing towards the first substrate 100, of the portion of the filling portion 500 on the light-emitting unit 300 and the dam 400. That is, the fourth face S6 of the limiting dam 201 is in direct contact with the portion of the filling portion 500 on the light-emitting unit 300 and the dam 400. Thus, the distances between the first region S61, the second region S62 and the third region S63 in the fourth face S6 of the limiting dam 201 and the first substrate 100 are related to morphology extending along a face, facing towards the first substrate 100, of the portion of the filling portion 500 on the light-emitting unit 300 and the dam 400. In some embodiments, in the case that the face, facing towards the first substrate 100, of the portion of the filling portion 500 on the light-emitting unit 300 and the dam 400 is flush, the first region S61, the second region S62 and the third region S63 in the fourth face S6 of the limiting dam 201 are flush.

In the embodiments of the present disclosure, as shown in FIG. 10 and FIG. 11, the light-emitting unit 300 in the chip structure 000 further includes a connection electrode 300b. The connection electrode 300b in the light-emitting unit 300 is disposed on a side, furthest from the first substrate 100, of the light-emitting unit 300.

Specifically, in the case that the chip structure 000 is determined as a display pixel (or a sub-pixel) of the display substrate, the connection electrode 300b is configured to connect the chip structure 000 to a drive circuity to electrically control and affix the chip. For example, the chip structure 000 is electrically connected to the drive circuity by welding. For example, the drive circuity is disposed in a drive substrate, and the chip structures 000 are arranged in any array on the drive substrate.

In some embodiments, a distance between a face, facing away from the first substrate 100, of the connection electrode 300b and the first substrate 100 is greater than a distance between the second face S2 of the dam 400 and the first substrate 100.

In the process of manufacturing the chip structure 000, the connection electrode 300b in the light-emitting unit 300 is affixed on the temporary substrate by the first adhesive, and the side, facing towards the first substrate 100, of the connection electrode 300b is ashed upon removal of the temporary substrate, such that a remaining adhesive between the chip 000 is removed.

In some embodiments, a dis-adhesive layer is disposed between the temporary substrate and the chip structure 000, the connection electrode 300b is in direct contact with the dis-adhesive layer, and the dam 400 is manufactured on the dis-adhesive layer. Thus, upon removal of the temporary substrate (removal of the dis-adhesive layer to separate the temporary substrate from the chip structure 000) and prior to ashing of the connection electrode 300b, a distance between a side, facing away from the first substrate 100, of the connection electrode 300b and the first substrate is equal to the distance between the second face S2 of the dam 400 and the first substrate 100. Upon the ashing process, a part on a side, facing away from the first substrate 100, of the dam 400 is ashed, and thus a distance between a face, facing away from the first substrate 100, of the connection electrode 300b is greater than the distance between the second face S2 of the dam 400 and the first substrate 100. In this case, the side, facing away from the first substrate 100, of the connection electrode 300b in the light-emitting unit 300 is welded on the drive backplane by a welding process. Thus, in the case that the distance between the face, facing away from the first substrate 100, of the connection electrode 300b is greater than the distance between the second face S2 of the dam 400 and the first substrate 100, stability of welding between the connection electrode 300b and the drive backplane is greater.

In some embodiments, a dis-adhesive layer is disposed between the temporary substrate and the chip structure 000, a cured product of the first adhesive is further present between the connection electrode 300b and the dis-adhesive layer, and the dam 400 is manufactured on the dis-adhesive layer. Thus, upon removal of the temporary substrate (removal of the dis-adhesive layer to separate the temporary substrate from the chip structure 000) and prior to ashing of the connection electrode 300b, a distance between a side, facing away from the first substrate 100, of the connection electrode 300b and the first substrate is less than the distance between the second face S2 of the dam 400 and the first substrate 100. In this case, a part on a side, facing away from the first substrate 100, of the dam 400 and the cured product of the first adhesive are ashed, the connection electrode 300b is not prone to erosion due to the ashing action, and thus a distance between a face, facing away from the first substrate 100, of the connection electrode 300b is greater than, equal to, or less than the distance between the second face S2 of the dam 400 and the first substrate 100 (depending on an erosion rate of the dam 400 and the cured product of the first adhesive in the ashing process). For example, by designing a thickness of the cured product of the first adhesive between the connection electrode 300b and the dis-adhesive layer, the distance between the face, facing away from the first substrate 100, of the connection electrode 300b is less than or equal to the distance between the second face S2 of the dam 400 and the first substrate 100. As such, the dam 400 greatly protect the side face of the chip structure 000 from light leakage. Meanwhile, good welding is achieved by heightening pads on a bearing base corresponding to the chip structure 000 or by increasing an overall thickness of a conductive portion of the connection electrode region using the thickness of the solder.

In the embodiments of the present disclosure, a dis-adhesive layer is disposed between the temporary substrate and the chip structure 000, the dam 400 is manufactured on the dis-adhesive layer, and the filling portion 500 is in direct contact with the dis-adhesive layer. Thus, upon removal of the temporary substrate (removal of the dis-adhesive layer to separate the temporary substrate from the chip structure 000) and prior to ashing of the connection electrode 300b, a distance between a side, facing away from the first substrate 100, of the filling portion 500 and the first substrate is equal to the distance between the second face S2 of the dam 400 and the first substrate 100.

In some embodiments, in the ashing process, an ashing efficiency of the side, facing away from the first substrate 100, of the dam 400 is lower than an ashing efficiency of the side, facing away from the first substrate 100, of the filling portion 500. Thus, as shown in FIG. 10 and FIG. 11, the distance between the second face S2 of the dam 400 and the first substrate 100 is greater than the distance between the face on the side, away from the first substrate 100, of the portion of the filling portion 500 between the dam 400 and the light-emitting unit 300 and the first substrate 100.

In some embodiments, in the ashing process, an ashing efficiency of the side, facing away from the first substrate 100, of the dam 400 is higher than an ashing efficiency of the side, facing away from the first substrate 100, of the filling portion 500. Thus, as shown in FIG. 10 and FIG. 11, the distance between the second face S2 of the dam 400 and the first substrate 100 is less than the distance between the face on the side, away from the first substrate 100, of the portion of the filling portion 500 between the dam 400 and the light-emitting unit 300 and the first substrate 100.

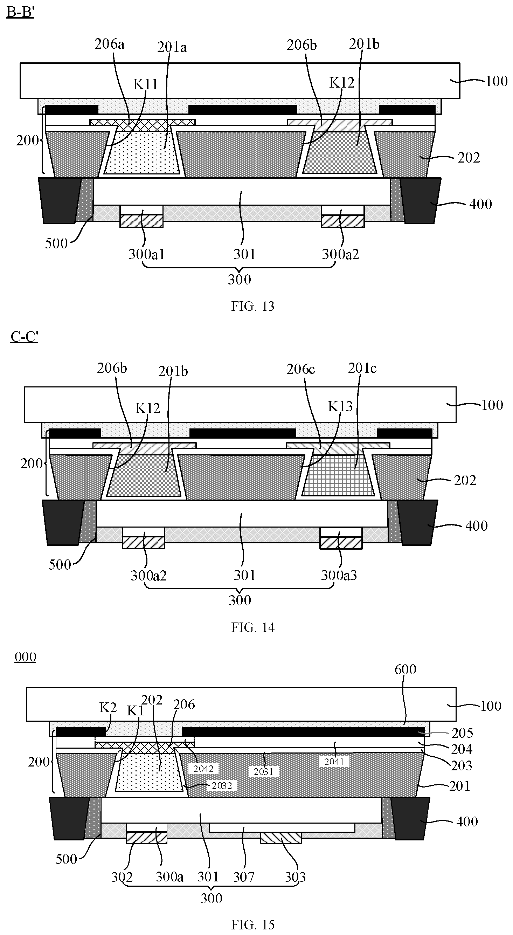

In the present disclosure, as shown in FIG. 12, FIG. 13, and FIG. 14, FIG. 12 is a top view of a chip structure according to some embodiments of the present disclosure. FIG. 13 is a schematic diagram of a film layer structure of the chip structure shown in FIG. 12 at a position B-B'. FIG. 14 is a schematic diagram of a film layer structure of the chip structure shown in FIG. 12 at a position C-C'. The plurality of light-emitting functional sub-layers in the light-emitting unit 300 include a first light-emitting functional sub-layer 300a1, a second light-emitting functional sub-layer 300a2, and a third light-emitting functional sub-layer 300a3. The first light-emitting functional sub-layer 300a1, the second light-emitting functional sub-layer 300a2, and the third light-emitting functional sub-layer 300a3 emit the first light in the operating state.

Correspondingly, the plurality of opening regions in the limiting dam 201 include a first opening region K11, a second opening region K12, and a third opening region K13. The first opening region K11 is opposite to the first light-emitting functional sub-layer 300a1, the second opening region K12 is opposite to the second light-emitting functional sub-layer 300a2, and the third opening region K13 is opposite to the third light-emitting functional sub-layer 300a3.

The first opening region K11 and the second opening region K12 are arranged in a line in a first direction X, and the second opening region K12 and the third opening region K13 are arranged in a line in a second direction Y. The first direction X is intersected with the second direction Y. For example, the first direction X is perpendicular to the second direction Y. In the present disclosure, a region enclosed by an outer counter of the limiting dam 201 is a rectangle, and the first opening region K11, the second opening region K12, and the third opening region K13 are in a rectangular shape.

The plurality of optical functional portions 201 in the color conversion unit 200 include a first optical functional portion 201a, a second optical functional portion 201b, and a third optical functional portion 201c. The first optical functional portion 201a is disposed in the first opening region K11, the second optical functional portion 201b is disposed in the second opening region K12, and the third optical functional portion 201c is disposed in the third opening region K13.

In this case, the first light emitted by the first light-emitting functional sub-layer 300a1 irradiates to the first optical functional portion 201a, and is converted to light of another color by the first optical functional portion 201a. The first light emitted by the second light-emitting functional sub-layer 300a1 irradiates to the second optical functional portion 201b, and is converted to light of another color by the second optical functional portion 201b. The first light emitted by the third light-emitting functional sub-layer 300a3 irradiates to the third optical functional portion 201c, and is transmitted to the third optical functional portion 201c or converted by the third optical functional portion 201c.

Illustratively, the chip structure 000 has a red sub-pixel R, a green sub-pixel G, and a blue sub-pixel B. The first light emitted by the first light-emitting functional sub-layer 300a1, the second light-emitting functional sub-layer 300a2, and the third light-emitting functional sub-layer 300a3 in the light-emitting unit 300 includes at least one of the blue light and ultraviolet light.

The first optical functional portion 201a is configured to convert the first light to the red light. Illustratively, the first optical functional portion 201a includes red quantum dots for converting the first light to the red light. In some embodiments, the first optical functional portion 201a further includes scattering particles for scattering light. Upon irradiation of the first light emitted by the first light-emitting functional sub-layer 300a1 to the first optical functional portion 201a in the first opening region K11, the first light is converted to red light by the red quantum dots, and the first light and the red light are scattered by the scattering particles, such that much first light is converted to red light by the red quantum dots, and an emission angle of the converted red light is large to ensure that a viewing angle of a display substrate integrated with the chip structure 000 is large. Thus, the red sub-pixel R in the chip structure 000 includes the first light-emitting functional sub-layer 300a2 and the first optical functional portion 201a.

The second optical functional portion 201b is configured to convert the first light to the green light. Illustratively, the second optical functional portion 201b includes green quantum dots for converting the first light to the green light. In some embodiments, the second optical functional portion 201b further includes scattering particles for scattering light. Upon irradiation of the first light emitted by the second light-emitting functional sub-layer 300a2 to the second optical functional portion 201b in the second opening region K12, the first light is converted to green light by the green quantum dots, and the first light and the green light are scattered by the scattering particles, such that much first light is converted to green light by the green quantum dots, and an emission angle of the converted green light is large to ensure that a viewing angle of a display substrate integrated with the chip structure 000 is large. Thus, the red sub-pixel R in the chip structure 000 includes the first light-emitting functional sub-layer 300a1 and the first optical functional portion 201a. The green sub-pixel G in the chip structure 000 includes the second light-emitting functional sub-layer 300a2 and the second optical functional portion 201b.

The third optical functional portion 201c is configured to convert the first light to the blue light or maintain and emit the blue light. For example, in the case that the first light only includes blue light, the third optical functional portion 201c is a transparent portion or includes blue quantum dots. The transparent portion is configured to directly transmit the first light, and the blue quantum dots is configured to convert the first light to blue light with different wavelength of the first light. In some embodiments, the third optical functional portion 201c further includes scattering particles for scattering light. Upon irradiation of the first light emitted by the third light-emitting functional sub-layer 300a3 to the third optical functional portion 201c in the third opening region K13, the first light is scattered by the scattering particles, such that an emission angle of the blue light is large to ensure that a viewing angle of a display substrate integrated with the chip structure 000 is large. For example, in the case that the first light includes ultraviolet light, the third optical functional portion 201c includes blue quantum dots for converting the first light to the blue light, or, the third optical functional portion 201c includes scattering particles for scattering light and blue quantum dots for converting the ultraviolet light to the blue light. Upon irradiation of the first light emitted by the second light-emitting functional sub-layer 300a2 to the third optical functional portion 201c in the third opening region K13, the ultraviolet light in the first light is converted to blue light by the blue quantum dots, and the first light and the blue light are scattered by the scattering particles, such that much ultraviolet light is converted to blue light by the blue quantum dots, an emission angle of the converted blue light is large to ensure that a viewing angle of a display substrate integrated with the chip structure 000 is large. Thus, the blue sub-pixel B in the chip structure 000 includes the third light-emitting functional sub-layer 300a3 and the third optical functional portion 201c.

In the present disclosure, in the case that the limiting dam 201 is made of an organic material with a reflective property, light emitted from a side edge of the optical functional portion 201 is reflected to the optical functional portion 201 by the limiting dam 201, such that quantum dots in the optical functional portion 201 convert blue light or ultraviolet light in the reflected light to light of a corresponding color. As such, an excitation efficiency of the quantum dots is further improved. In addition, the light reflected by the limiting dam 201 is emitted from a side, facing towards the first substrate 100, of the optical functional portion 201, such that the luminous efficiency of the chip structure 000 is improved.

In some embodiments, the color conversion unit 200 in the chip structure 000 further includes an inorganic encapsulation structure for encapsulating the optical functional portion 202. In the process of manufacturing the chip structure 000, as the limiting dam 201 in the color conversion unit 200 is formed on the first face S1 of the dam 400, the inorganic encapsulation structure in the color conversion unit 200 does not encapsulate the whole limiting dam 201, and encapsulates the optical functional portion 202 in the opening region K1 of the limiting dam 201 to encapsulate the optical functional portion 202.

Thus, the inorganic encapsulation structure is not disposed on an outer side face (that is, the second outer counter face S7) of the limiting dam 201 of the color conversion unit 200, and the second outer counter face S7 of the limiting dam 201 is in direct contact with an external environment. That is, the second outer counter face S7 of the limiting dam 201 is exposed in the external environment.

Illustratively, as shown in FIG. 15, FIG. 15 is a schematic diagram of a film layer structure of a chip structure according to some embodiments of the present disclosure. The color conversion unit 200 in the chip structure 000 further includes a first encapsulation layer 203. The first encapsulation layer 203 is disposed between the first substrate 100 and the limiting dam 201, and a part of the first encapsulation layer 203 is disposed in the opening region K1 of the limiting dam 201. The optical functional portion 202 in the opening region K1 of the limiting dam 201 is disposed between the first encapsulation layer 203 and the first substrate 100, and an orthographic projection of the optical functional portion 203 on the first substrate 100 is within an orthographic projection of the first encapsulation layer 203 on the first substrate 100.

As such, even if moisture and oxygen in the external environment enter the opening region K1 through the limiting dam 201, the moisture and oxygen are isolated by the part of the first encapsulation layer 203 extending in the opening region K1 to ensure that the moisture and oxygen do not erode the optical functional portion 203 in the opening region K1, such that reliability of the optical functional portion 203 is great.

In the present disclosure, in the process of manufacturing the chip structure 000, upon formation of the limiting dam 201 on the first face S1 of the dam 400, the first encapsulation layer 203 is formed on a side, facing away from the dam 400, of the limiting dam 201, and then the optical functional portion 202 is formed in the opening region K1 of the limiting dam 201. Thus, the first encapsulation layer 203 includes a first encapsulation portion 2031 on a side, facing towards the first substrate 100, of the limiting dam 201 and a second encapsulation portion 2032 connected to the first encapsulation portion 2031 and extending in the opening region K1 of the limiting dam 201.

The second encapsulation portion 2032 in the first encapsulation layer 203 covers an inner sidewall of the opening region K1 and an opening of the opening region K1 facing away from the first substrate 100. The optical functional portion 202 in the opening region K1 of the limiting dam 201 is in contact with the second encapsulation portion 2032. Thus, the moisture and oxygen in the external environment entering the opening region K1 through the limiting dam 201 are isolated by the second encapsulation portion 2032 in the first encapsulation layer 203.

In some embodiments, as shown in FIG. 15, the color conversion unit 200 in the chip structure 000 further includes a second encapsulation layer 204. The second encapsulation layer 204 is disposed between the first substrate 100 and the first encapsulation layer 203, and the optical functional portion 202 in the color conversion unit 200 is disposed between the first encapsulation layer 203 and the second encapsulation layer 204. The first encapsulation layer 203 is in contact with the second encapsulation layer 204 in the color conversion unit 200 to seal the optical functional portion 202.

Illustratively, the second encapsulation layer 204 includes a third encapsulation portion 2041 in contact with the first encapsulation portion 2031 in the first encapsulation layer 203 and a fourth encapsulation portion 2042 connected to the third encapsulation portion 2041. The optical functional portion 202 is disposed on a side, facing away from the first substrate 100, of the fourth encapsulation portion 2042 in the second encapsulation layer 204, and an orthographic projection of the optical functional portion 202 on the first substrate 100 is within an orthographic projection of the fourth encapsulation portion 2042 on the first substrate 100.

Thus, the optical functional portion 202 is disposed between the fourth encapsulation portion 2042 in the second encapsulation layer 204 and the second encapsulation portion 2032 in the first encapsulation layer 203. Various positions of the optical functional portion 202 are completely encapsulated by the fourth encapsulation portion 2042 in the second encapsulation layer 204 and the second encapsulation portion 2032 in the first encapsulation layer 203, such that an encapsulation effect of the optical functional portion 202 is great based on matching of the first encapsulation layer 203 and the second encapsulation layer 204, and the reliability of the optical functional portion 202 is improved.

In the embodiments of the present disclosure, in the case that the filling portion 500 in the chip structure 000 is not disposed on the side, facing towards the first substrate 100, of the light-emitting unit 300, a side, facing away from the first substrate 100, of the second encapsulation portion 2032 in the first encapsulation layer 203 entering the opening region K1 of the limiting dam 201 is in direct contact with a side, facing towards the first substrate 100, of the first semiconductor layer 301 in the light-emitting unit 300. In this case, a distance between the light-emitting functional sub-layer 300a in the light-emitting unit 300 and the corresponding optical functional portion 202 is reduced, such that much light emitted by the light-emitting functional sub-layer 300a enters the corresponding optical functional portion 202, and the luminous efficiency of the chip structure 000 is improved. Furthermore, in the case that a plurality of light-emitting functional sub-layers 300a are disposed, the distance between the light-emitting functional sub-layer 300a and the corresponding optical functional portion 202 is less, such that the light from the light-emitting functional sub-layer 300a to other optical functional portions 202 is reduced or avoided, and the color crosstalk in the chip structure 000 is reduced or avoided.

In some embodiments, the first encapsulation layer 203 and the second encapsulation layer 204 in the color conversion unit 200 are continuous film layer structures at various positions. In some embodiments, color conversion unit 200 include a plurality of laminated encapsulation sub-layers. In some embodiments, the first encapsulation layer 203 and the second encapsulation layer 204 in the color conversion unit 200 are made of an inorganic insulative material. In some embodiments, the inorganic insulative material includes at least one of silicon oxide, silicon nitride, silicon nitrogen oxide. As such, the moisture and oxygen in the external environment do not erode the optical functional portion 202 by matching of the second encapsulation layer 204 and the first encapsulation layer 203.

It should be noted that as a plurality of opening regions K1 are defined in the limiting dam 201 in the present disclosure, and the optical functional portion 202 is disposed in each opening region K1, the first encapsulation layer 203 extends in each opening region K1 in the limiting dam 201, and various optical functional portions 202 in the color conversion unit 200 are completely encapsulated by matching of the first encapsulation layer 203 and the second encapsulation layer 204, such that various optical functional portions 202 in the color conversion unit 200 are not eroded by the moisture and oxygen in the external environment.

In the embodiments of the present disclosure, as shown in FIG. 15, the color conversion unit 200 in the chip structure 000 further includes a light-shielding layer 205. The light-shielding layer 205 is disposed between the first substrate 100 and the limiting dam 203. For example, the light-shielding layer 205 is disposed between the second encapsulation layer 204 and the first substrate. For example, the light-shielding layer 205 is disposed between the first encapsulation layer 203 and the second encapsulation layer 204.

An aperture K2 is defined in the light-shielding layer 205. A plurality of apertures K2 in the light-shielding layer 205 are defined, and are in one-to-one correspondence with the plurality of opening regions K1 in the limiting dam 203. An orthographic projection of the aperture K2 on the first substrate 100 is overlapped with an orthographic projection of the corresponding opening region K1 on the first substrate 100. For example, the orthographic projection of the opening region K1 in the limiting dam 201 on the first substrate 100 is overlapped with an orthographic projection of the corresponding aperture K2 on the first substrate 100.

It should be noted that as light-emitting sides of the light-emitting functional sub-layers 300a in the light-emitting unit 300 face towards the corresponding opening regions K1, and the orthographic projection of each light-emitting functional sub-layer 300a on the first substrate 100 is overlapped with the orthographic projection of a corresponding opening region K1 on the first substrate 100, the orthographic projection of each light-emitting functional sub-layer 300a in the light-emitting unit 300 on the first substrate 100 is within the orthographic projection of the optical functional portion 202 in the corresponding opening region K1 on the first substrate 100, such that light emitted by the light-emitting functional sub-layer 300a irradiates to the optical functional portion 202 in the corresponding opening region K1 in the limiting dam 201, and the light with converted color is emitted by passing through the first substrate 100 through the corresponding aperture K2 upon conversion of the color of the light by the optical functional portion 202.

In some embodiments, the color conversion unit 200 in the chip structure 000 further includes a light-filtering unit 206 between the first substrate 100 and the optical functional portion 202. A plurality of light-filtering units in the color conversion unit 200 are disposed, and the plurality of light-filtering units 206 are in one-to-one correspondence with the plurality of apertures K2 in the light-shielding layer 205. An orthographic projection of the light-filtering unit 206 on the first substrate 100 is overlapped with an orthographic projection of a corresponding aperture K2 on the first substrate 100.

Illustratively, as shown in FIG. 13 and FIG. 14, the plurality of light-filtering units in the color conversion unit 200 include a first light-filtering unit 206a, a second light-filtering unit 206b, and a third light-filtering unit 206c. The first light-filtering unit 206a is correspondingly disposed to the first optical functional portion 201a, the second light-filtering unit 206b is correspondingly disposed to the second optical functional portion 201b, and the third light-filtering unit 206c is correspondingly disposed to the third optical functional portion 201c. Thus, the red sub-pixel R in the chip structure 000 includes the first light-filtering unit 206a, the green sub-pixel G in the chip structure 000 includes the second light-filtering unit 206b, and the blue sub-pixel B in the chip structure 000 includes the third light-filtering unit 206c.

For example, first light emitted by the first light-emitting functional sub-layer 300a1, the second light-emitting functional sub-layer 300a2, and the third light-emitting functional sub-layer 300a3 in the light-emitting unit 300 is blue light, the first light-filtering unit 206a is a red color blocker, and the red color blocker transmits red light and absorbs light with other colors. As such, light emitted from the first optical functional portion 201a is emitted upon passing through the first light-filtering unit 206a, and the first light-filtering unit 206a filters light of other colors than the red light, such that the red sub-pixel R in the chip structure 000 filters blue light. It should be noted that, in some embodiments, the first light-filtering unit 206a is a film layer for transmitting red light and reflecting blue light. As such, upon irradiation of the light emitted from the first optical functional portion 201a to the first light-filtering unit 206a, red light in the light transmits the first light-filtering unit 206a and is emitted, and blue light in the light is reflected to the first optical functional portion 201a by the first light-filtering unit 206a, such that red quantum dots in the first optical functional portion 201a excites the blue light to red light, and the excitation efficiency of red quantum dots is further improved.

For example, first light emitted by the first light-emitting functional sub-layer 300a1, the second light-emitting functional sub-layer 300a2, and the third light-emitting functional sub-layer 300a3 in the light-emitting unit 300 is blue light, the second light-filtering unit 206b is a green color blocker, and the green color blocker transmits green light and absorbs light with other colors. As such, light emitted from the second optical functional portion 201b is emitted upon passing through the second light-filtering unit 206b, and the second optical functional portion 201b filters light of other colors than the green light, such that the green sub-pixel G in the chip structure 000 filters green light. It should be noted that, in some embodiments, the second optical functional portion 201b is a film layer for transmitting green light and reflecting blue light. As such, upon irradiation of the light emitted from the second optical functional portion 201b to the second light-filtering unit 206b, green light in the light transmits the second light-filtering unit 206b and is emitted, and blue light in the light is reflected to the second optical functional portion 201b by the second optical functional portion 201b, such that green quantum dots in the second optical functional portion 201b excites the blue light to green light, and the excitation efficiency of red quantum dots is further improved.

It should be noted that film layer structures of the first light-filtering unit 206a and the second light-filtering unit 206b are the same and are manufactured by a single process. For example, the first light-filtering unit 206a and the second light-filtering unit 206b are film layers for transmitting red light and green light and reflecting blue light.

For example, first light emitted by the first light-emitting functional sub-layer 300a1, the second light-emitting functional sub-layer 300a2, and the third light-emitting functional sub-layer 300a3 in the light-emitting unit 300 is blue light, the third light-filtering unit 206c is a blue color blocker, and the blue color blocker transmits blue light and absorbs light with other colors. As such, light emitted from the third light-filtering unit 206c is emitted upon passing through the third light-filtering unit 206c third light-filtering unit 206c, and the third light-filtering unit 206c filters light of other colors than the blue light, such that the blue sub-pixel B in the chip structure 000 emits pure blue light.

For example, first light emitted by the first light-emitting functional sub-layer 300a1, the second light-emitting functional sub-layer 300a2, and the third light-emitting functional sub-layer 300a3 in the light-emitting unit 300 is blue light, the third light-filtering unit 206c is a transparent block transmitting blue light.

It should be noted that as an orthographic projection of the light-filtering unit 206 in the color conversion unit 200 on the first substrate 100 is overlapped with an orthographic projection of the corresponding apertures K1 in the light-shielding layer 201 on the first substrate 100, a part of the light-shielding layer 201 is disposed between adjacent two light-filtering units 206 in the color conversion unit 200 in a direction parallel to an extension face of the first substrate 100. As such, light emitted from a side face of a light-filtering unit 206 in the color conversion unit 200 is absorbed by the light-shielding layer 201, and a probability of color crosstalk in the chip structure 000 is effectively reduced.

In the embodiments of the present disclosure, the second encapsulation layer 204 in the color conversion unit 200 is disposed between the light-shielding layer 201 and the limiting dam 201, and position relationships of the second encapsulation layer 204 in the color conversion unit 200 and the light-filtering unit 206 are several cases, and the embodiments of the present disclosure are illustrated by taking following two implementations as an example.

In a first implementation, as shown in FIG. 15, the light-filtering unit 206 in the color conversion unit 200 is disposed on a side, facing away from the first substrate 100, of the second encapsulation layer 204.

In this case, in the process of manufacturing the color conversion unit 200 in the chip structure, the limiting dam 201, the first encapsulation layer 203, and the optical functional portion 202 are sequentially formed on the dam 400, the light-emitting unit 300, and the filling portion 500 between the dam 400 and the light-emitting unit 300, then the light-filtering unit 206 and the second encapsulation layer 204 are sequentially formed on the optical functional portion 202, and the light-shielding layer 205 is eventually formed on a side, facing away from the limiting dam 201, of the second encapsulation layer 204.

As such, the side, facing away from the first substrate 100, of the light-filtering unit 206 is in direct contact with the side, facing towards the first substrate 100, of the optical functional portion 202. In addition, in this case, the optical functional portion 202 and the light-filtering unit 206 are encapsulated by matching of the first encapsulation layer 203 and the second encapsulation layer 204.

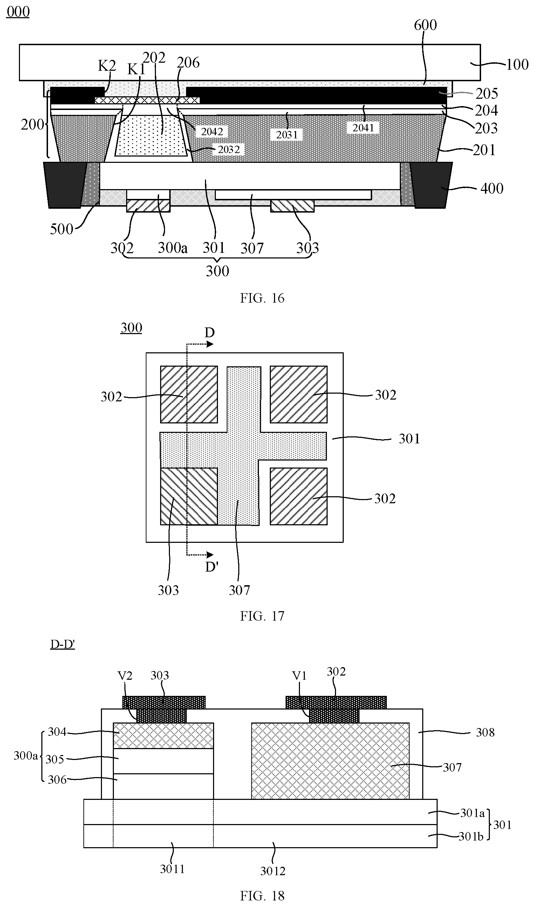

In a second implementation, as shown in FIG. 16, FIG. 16 is a schematic diagram of a film layer structure of a chip structure according to some embodiments of the present disclosure. The light-filtering unit 206 in the color conversion unit 200 is disposed on a side, facing towards the first substrate 100, of the second encapsulation layer 204.

In this case, in the process of manufacturing the color conversion unit 200 in the chip structure, the limiting dam 201, the first encapsulation layer 203, and the optical functional portion 202 are sequentially formed on the dam 400, the light-emitting unit 300, and the filling portion 500 between the dam 400 and the light-emitting unit 300, then the second encapsulation layer 204 and the light-filtering unit 206 are sequentially formed on the optical functional portion 202, and the light-shielding layer 205 is eventually formed on a side, facing away from the optical functional portion 202, of the light-filtering unit 206.

As such, the side, facing away from the first substrate 100, of the light-filtering unit 206 is in direct contact with the side, facing towards the first substrate 100, of the second encapsulation layer 205.

In some embodiments, the orthographic projection of the light-filtering unit 206 in the color conversion unit 200 on the first substrate 100 covers the orthographic projection of the corresponding opening region K1 in the limiting dam 201 on the first substrate 100. As such, light emitted from the optical functional portion 202 in the opening region K1 in the limiting dam 201 irradiates to the corresponding light-filtering unit 206, such that a filtering effect of the light by the light-filtering unit 206 is great, and color of light emitted from the corresponding aperture K2 in the light-shielding layer 205 is purer.

In addition, the orthographic projection of the light-filtering unit 206 in the color conversion unit 200 on the first substrate 100 covers the corresponding aperture K2 in the light-shielding layer 205. As such, light emitted from the light-filtering unit 206 is emitted from the corresponding aperture K2 in the light-shielding layer 205, and does not irradiate to other adjacent apertures K2 in the light-shielding layer 205, such that the probability of color crosstalk in the chip structure 000 is effectively reduced.

It should be noted that in the process of manufacturing the chip structure 000, the light-shielding layer 205 in the color conversion unit 200 in eventually formed. Thus, as shown in FIG. 15, in the case that the light-filtering unit 206 is disposed on the side, facing away from the first substrate 100, of the second encapsulation layer 204, portions at various positions of the second encapsulation layer 204 do not extend in the aperture K2 in the light-shielding layer 205; as shown in FIG. 16, in the case that the light-filtering unit 206 is disposed on the side, facing towards the first substrate 100, of the second encapsulation layer 204, the second encapsulation layer 204 does not extend in the aperture K2 in the light-shielding layer 205.

It should be further noted that in the process of manufacturing the color conversion unit 200 in the chip structure 000, various film layers in the color conversion unit 200 are sequentially formed in a direction from the dam 400 to the first substrate 100. Thus, as shown in FIG. 15, in the case that the light-filtering unit 206 is disposed on the side, facing away from the first substrate 100, of the second encapsulation layer 204, the light-filtering unit 206 is manufactured upon manufacturing of the optical functional portion 202 in the opening region K1 in the limiting dam 201, such that at least part of the light-filtering unit 206 extends in the opening region K1 in the limiting dam 201. As shown in FIG. 16, in the case that the light-filtering unit 206 is disposed on the side, facing towards the first substrate 100, of the second encapsulation layer 204, the second encapsulation layer 204 is manufactured upon manufacturing of the optical functional portion 202 in the opening region K1 in the limiting dam 201, such that a part of the second encapsulation layer 204 extends in the opening region K1 in the limiting dam 201.

In the embodiments of the present disclosure, the light-shielding layer 205 in the color conversion unit 200 has a fifth face facing towards the side of the first substrate 100, a sixth face facing away from the side of the first substrate 100, and a third outer counter face between the fifth face and the sixth face. In the process of manufacturing the color conversion unit 200 in the chip structure 000, the light-shielding layer 205 is formed upon formation of the first encapsulation layer 203 and the second encapsulation layer 204. Thus, the first encapsulation layer 203 and the second encapsulation layer 204 do not cover the third outer counter face of the light-shielding layer 205, and the third outer counter face of the light-shielding layer 205 is in direct contact with the external environment. That is, the third outer counter face of the light-shielding layer 205 is exposed in the external environment.

In this case, even if moisture and oxygen in the external environment enter the light-shielding layer 205 through third outer counter face of the light-shielding layer 205, the moisture and oxygen entering the light-shielding layer 205 are isolated by the first encapsulation layer 203 and the second encapsulation layer 204 as the optical functional portion 202 in the color conversion unit 200 is encapsulated by the first encapsulation layer 203 and the second encapsulation layer 204, such that the moisture and oxygen do not erode the optical functional portion 202.

It should be noted that as the first encapsulation layer 203, the second encapsulation layer 204, and the light-shielding layer 205 are formed on a side, facing away from the dam 400 and the light-emitting unit 300, of the limiting dam 201 in the process of manufacturing the color conversion unit 200 in the chip structure 000, the orthographic projections of the first encapsulation layer 203, the second encapsulation layer 204, and the light-shielding layer 205 on the first substrate 100 are within a region enclosed by the first outer counter of the orthographic projection of the limiting dam 201 on the first substrate 100 to ensure high stability of forming the first encapsulation layer 203,the second encapsulation layer 204, and the light-shielding layer 205.

In the embodiments of the present disclosure, in the process of manufacturing the chip structure 000, the color conversion unit 200 is manufactured on the dam 400, the light-emitting unit 300, and the filling portion 500 between the dam 400 and the light-emitting unit 300, and the first substrate 100 is bonded on a side, facing away from the dam 400 and the light-emitting unit 300, of the color conversion unit 200.

Thus, as shown in FIG. 15 and FIG. 16, the chip structure 000 further includes a transparent connection layer 600. The transparent connection layer is configured to connect the first substrate 100 to the color conversion unit 200. Specifically, the transparent connection layer is transparent to visible light. Illustratively, in the process of manufacturing the chip structure 000, upon formation of the color conversion unit 200, a transparent adhesive is coated on the light-shielding layer 205 in the color conversion unit 200, the first substrate 100 is disposed on the transparent adhesive, the transparent connection layer 600 is acquired upon curing of the transparent adhesive, and the first substrate is affixed on the color conversion unit 200.

In this case, a part of the transparent connection layer 600 is disposed between the light-shielding layer 205 in the color conversion unit 200 and the first substrate 100, and another part of the transparent connection layer 600 is disposed in various apertures K2 in the light-shielding layer 205.

For example, the first substrate 100 is a rigid substrate.

For example, the first substrate 100 is a flexible substrate.

For example, the first substrate 100 is made of glass.

For example, the first substrate 100 is made of polymer, for example PET.

For example, the first substrate 100 is made of a PET thin film.

In the embodiments of the present disclosure, an orthographic projection of the transparent connection layer 600 on the first substrate 100 is within the first substrate 100. Illustratively, in the process of manufacturing the chip structure 000, upon formation of the first substrate 100, a side, facing towards the color conversion unit 200, of the first substrate 100 requires to be ashed. In the ashing process, a part of the transparent connection layer 600 not covered by the color conversion unit 200 and the dam 400 is also removed. Thus, a space is present between an outer counter of the orthographic projection of the transparent connection layer 600 on the first substrate 100 and an outer counter of the first substrate 100, and the outer counter of the orthographic projection of the transparent connection layer 600 on the first substrate 100 and an outer counter of the orthographic projection of the dam 400 on the first substrate 100 extend in parallel. In the case that the first substrate 100 is made of glass, adjacent chip structures 000 on the chip motherboard are separated by laser cutting (for example, by applying external force upon laser hidden cutting), and removal of the transparent connection layer 600 between the adjacent chip structures 000 is conducive to avoiding adhesion of chip 000 upon cutting.

In some embodiments, the optical functional portion 202 in the color conversion unit 200 is generally formed by an inkjet printing process, and an inkjet printing device prints on a side, facing away from the light-emitting unit 300, of the limiting dam 201 in the inkjet printing process and does not print on a side, facing away from the first substrate 100, of the limiting dam 201. Thus, in the chip structure 000, the optical functional portion 202 shows as following morphology: a face, facing towards the first substrate 100, of the optical functional portion 202 includes a cambered face (for example, forming a cambered face as a whole), and a face, facing towards the first substrate 100, of the optical functional portion 202 in the color conversion unit 200 extends along a face of the light-emitting unit 300 close to the first substrate 100.

In the present disclosure, the face, facing towards the first substrate 100, of the optical functional portion 202 is a cambered convex face or a cambered concave face. The optical functional portion 202 has different types of faces depending on a material of the limiting dam 201. For example, in the case that the limiting dam 201 needs a lyophobicity material, the face, facing towards the first substrate 100, of the optical functional portion 202 is a cambered convex; in the case that the limiting dam 201 needs a lyophily material, the face, facing towards the first substrate 100, of the optical functional portion 202 is a concave convex. The lyophobicity and the lyophily are described relative to ink in the optical functional portion 202.

In some embodiments, the light-emitting unit 300 in the chip structure 000 includes a plurality of light-emitting chips, and each light-emitting chip includes a light-emitting functional sub-layer 300a. The light-emitting chip is a LED chip. It should be noted that the LED chip is a LED chip with a normal size, a mini LED chip, a micro LED chip, which is not limited in the embodiments of the present disclosure.

In the embodiments of the present disclosure, referring to FIG. 17 and FIG. 18, FIG. 17 is a top view of a light-emitting unit according to some embodiments of the present disclosure, and FIG. 18 is a schematic diagram of a film layer structure of the light-emitting unit shown in FIG. 17 at a position D-D'. The light-emitting unit 300 further includes a first connection electrode 302 and a plurality of second connection electrodes 303.

The first connection electrode 302 in the light-emitting unit 300 is electrically connected to the first semiconductor layer 301, and the plurality of second connection electrodes 303 in the light-emitting unit 300 are in one-to-one correspondence with the plurality of light-emitting functional sub-layers 300a, are disposed on a side, facing away from the first semiconductor layer 301, of corresponding light-emitting functional sub-layers 300a, and are electrically connected to the corresponding light-emitting functional sub-layers 300a.

In the present disclosure, each light-emitting functional sub-layer 300a in the light-emitting unit 300 includes a current diffusion layer 304, a second semiconductor layer 305, and a light-emitting layer 306 that are laminated in a direction perpendicular to and facing towards the first substrate 100. That is, the light-emitting layer 306 in the light-emitting functional sub-layer 300a is closer to the first semiconductor layer 301 than the current diffusion layer 304.

The light-emitting layer 306 in each light-emitting functional sub-layer 300a is connected to the first semiconductor layer 301. The first semiconductor layer 301 in the light-emitting unit 300 is disposed on light-emitting sides of various light-emitting functional sub-layers 300a. The first semiconductor layer 301 is in contact with a side, facing away from the second semiconductor layer 305, of the light-emitting layer 306 in the light-emitting functional sub-layer 300a.

In the present disclosure, a side of the current diffusion layer 304 in each light-emitting functional sub-layer 300a is in contact with the second semiconductor layer 305, and another side of the current diffusion layer 304 is lapped with the second connection electrode 303. That is, a side, facing away from the second semiconductor layer 305, of the current diffusion layer 304 in each light-emitting functional sub-layer 300a is lapped with the corresponding second connection electrode 303. Thus, the second pad electrode 303 is electrically connected to the light-emitting functional sub-layer 300a by lapping the current diffusion layer 304 in the light-emitting functional sub-layer 300a with the second connection electrode 303. In some embodiments, the current diffusion layer 304 is made of indium tin oxide (ITO), and is disposed in the light-emitting functional sub-layer 300a to facilitate transmission of holes and improvement of the electrical performance of the chip structure 000.

In the embodiments of the present disclosure, the light-emitting unit 300 further includes a common electrode layer 307 connected to the auxiliary portion 3012 in the first semiconductor layer 301. A side, facing away from the first semiconductor layer 301, of the common electrode layer 307 is lapped with the first connection electrode 302. Thus, the side of the common electrode layer 307 is connected to the first semiconductor layer 301, and another side of the common electrode layer 307 is connected to the first connection electrode 302, such that electrical connection between the first connection electrode 302 and the first semiconductor layer 302 is achieved. In some embodiments, the common electrode layer 307 functions as current spreading.

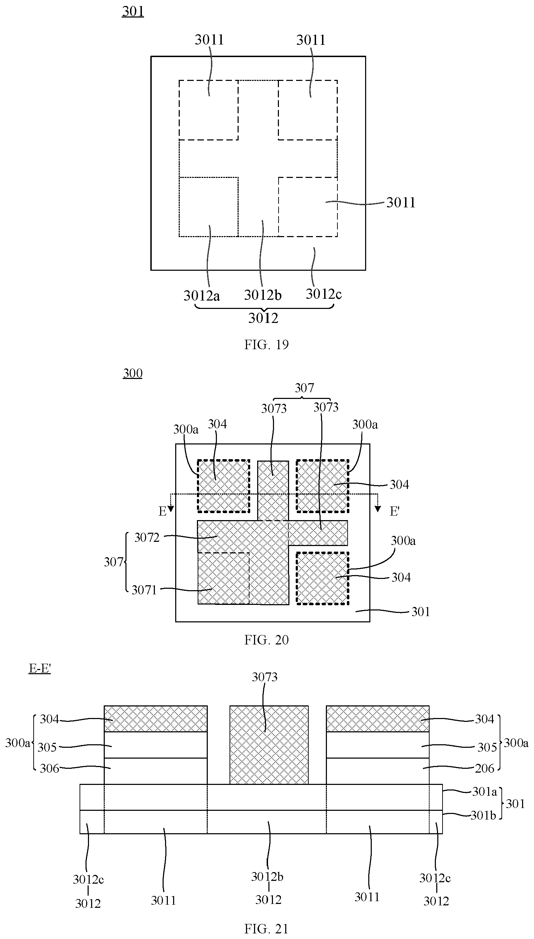

In the present disclosure, referring to FIG. 19, FIG. 20, and FIG. 21, FIG. 19 is a top view of a first semiconductor layer according to some embodiments of the present disclosure, FIG. 20 is a top view of a light-emitting unit according to some embodiments of the present disclosure, and FIG. 21 is a schematic diagram of a film layer structure of the light-emitting unit shown in FIG. 20 at a position E-E'. It should be noted that an insulative protection layer 308, the first connection electrode 302, and the second connection electrodes 304 are not shown for convenient viewing. A plurality of connection portions 3011 in the first semiconductor layer 301 are in one-to-one correspondence with the plurality of second connection electrodes 304, and an orthographic projection of each connection portion 3011 on the first substrate 100 is overlapped with an orthographic projection of the corresponding second connection electrode 303 on the first substrate 100. For example, an outer boundary of the orthographic projection of each connection portion 3011 on the first substrate 100 is coincident with an outer boundary of the orthographic projection of the corresponding second connection electrode 303 on the first substrate 100.

The auxiliary portion 3012 in the first semiconductor layer 301 includes a first auxiliary portion 3012a, a second auxiliary portion 3012b, and a third auxiliary portion 3012c.

An orthographic projection of the first auxiliary portion 3012a on the first substrate 100 is overlapped with an orthographic projection of the first connection electrode 302 on the first substrate 100. For example, an outer boundary of the orthographic projection of the first auxiliary portion 3012a on the first substrate 100 is coincident with an outer boundary of the orthographic projection of the first connection electrode 302 on the first substrate 100.

A part of the second auxiliary portion 3012b is disposed between adjacent connection portions 3011, and another part of the second auxiliary portion 3012b is disposed between the first auxiliary portion 3012a and the connection portion 3011.

The third auxiliary portion 3012c surrounds the first auxiliary portion 3012a, the second auxiliary portion 3012b, and the plurality of connection portions 3011.

The first auxiliary portion 3012a, the second auxiliary portion 3012b, the third auxiliary portion 3012c, and the plurality of connection portions 3011 in the first semiconductor layer 301 form a whole layer planar structure.

In some embodiments, in the light-emitting unit 300, the second semiconductor layer 305 in the light-emitting functional sub-layer 300a is made of P-type gallium nitride, and the light-emitting layer 306 in the light-emitting functional sub-layer 300a is a multi-quantum well layer. As shown in FIG. 18 and FIG. 21, the first semiconductor layer 301 includes a first sub-layer 301a and a second sub-layer 301b that are laminated in a direction perpendicular to and facing towards the first substrate 100. That is, the second sub-layer 301b is closer to the connection layer 500. It is understandable that the first semiconductor layer 301 in the direction parallel to the extension face of the first substrate 100 in divided to the auxiliary portion 3012 and the plurality of connection portions 3011, and the first semiconductor layer 301 in the direction perpendicular to the extension face of the first substrate 100 in divided to the first sub-layer 301a and the second sub-layer 301b.

The first sub-layer 301a in the first semiconductor layer 301 is disposed between the second sub-layer 301b and the light-emitting layer 306 in the light-emitting functional sub-layer 300a. That is, the first sub-layer 301a is closer to the light-emitting layer 306 in the light-emitting functional sub-layer 300a than the second sub-layer 301b. The first sub-layer 301a in the first semiconductor layer 301 is made of N-type gallium nitride, and the second sub-layer 301b in the first semiconductor layer 301 is a gallium nitride buffer layer.

In this case, in the light-emitting unit 300, in the case that a cathode signal is supplied on the first connection electrode 302, and an anode signal is supplied on the second connection electrode 303 in the light-emitting functional sub-layer 300a, the light-emitting layer 304 in the light-emitting functional sub-layer 300a emits the first light.

In the embodiments of the present disclosure, the light-emitting unit 300 further includes an insulative protecting layer 308 on a side, facing away from the first semiconductor layer 301 of the common electrode layer 307 and the plurality of light-emitting functional sub-layers 300a. orthographic projections of the plurality of light-emitting functional sub-layers 300a and the common electrode layer 307 on the first semiconductor layer 301 are within an orthographic projection of the insulative protecting layer 308 on the first semiconductor layer 301, and the first connection electrode 302 and the plurality of second connection electrodes 303 are disposed on a side, facing away from the first semiconductor layer 301, of the insulative protecting layer 308.

In the present disclosure, a first connection via V1 corresponding to the first connection electrode 302 and a plurality of second connection vias V2 in one-to-one correspondence with the plurality of second connection electrodes 303 are defined in the insulative protecting layer 308. The first connection electrode 302 is lapped with a side, facing away from the first semiconductor layer 301, of the common electrode layer 307 through the first connection via V1. The plurality of second connection vias V2 are in one-to-one correspondence with the plurality of light-emitting functional sub-layers 300a, and each of the plurality of second connection electrodes 303 is lapped with a side, facing away from the light-emitting layer 306, of the current diffusion layer 304 in the corresponding light-emitting functional sub-layer 300a through the corresponding second connection via V2.

In the present disclosure, a thickness of the common electrode layer 307 is much greater than a thickness of the current diffusion layer 304. Illustratively, the face, facing away from the first semiconductor layer 301, of the common electrode layer 307 is flush with the face, facing away from the first semiconductor layer 301, of the current diffusion layer 304. That is, the thickness of the common electrode layer 307 is equal to a sum of thicknesses of the current diffusion layer 304, the second semiconductor layer 305, and the light-emitting layer 306. As such, sides, facing away from the connection layer 500, of the second connection electrodes 303 and the first connection electrode 302 in the light-emitting unit 300 are flush. As the second connection electrodes 303 and the first connection electrode 302 in the light-emitting unit 300 require to be welded to the drive backplane in the subsequent process of connecting the chip structure 000 to the drive backplane, the chip structure 000 is stably affixed to the drive backplane in the case that sides, facing away from the connection layer 500, of the second connection electrodes 303 and the first connection electrode 302 in the light-emitting unit 300 are flush.

In the embodiments of the present disclosure, the common electrode layer 307 includes a common electrode body portion 3071, a first support portion 3072 fixedly connected to the common electrode body portion 3071, two second support portions 3073 fixedly connected to the first support portion 3072. The common electrode body portion 3071 is electrically connected to the first connection electrode 302, the first support portion 3072 is disposed on a periphery of the common electrode body portion 3071, and each second support portion 3073 is disposed on a side, facing away from the common electrode body portion 3071, of the first support portion 3072. In the two second support portions 3073, one second support portion 3073 is disposed between two light-emitting functional sub-layer 300a adjacent in a row direction, and another second support portion 3073 is disposed between two light-emitting functional sub-layer 300a adjacent in a column direction. As such, a strength of the whole light-emitting unit 300 is great, a bulk of the common electrode layer 307 is great, and a resistance of the light-emitting unit 300 for transmitting the common cathode signal in the light-emitting unit 300.

In some embodiments, in the light-emitting unit 300, the first connection electrode 302 and the second connection electrodes 303 are disposed on a same layer and made of a same material. That is, the first connection electrode 302 and the second connection electrodes 303 are formed by a single patterning process.

In summary, the chip structure in the embodiments of the present disclosure includes a first substrate, light-emitting units, color conversion units, and dam layer. The dam layer surrounds the light-emitting units, and a maximum distance between a face, facing away from the color conversion unit, of the dam layer and the first substrate is greater than or equal to a maximum distance between a face, facing away from the first substrate, of a first semiconductor layer in the light-emitting unit. Thus, in the case that the first semiconductor layer generates optical waveguide phenomenon, light laterally transmitted in the first semiconductor layer is blocked by the dam layer upon emitted from any position of the edge. As such, even if the light entering the first semiconductor layer generates the optical waveguide phenomenon, the dam layer is disposed to block the light emitted from the edge of the first semiconductor layer, such that a probability of light leakage of the chip structure is efficiently reduced, and the display effect of the display substrate integrated with the chip structure is great.

The embodiments of the present disclosure further provide a method for manufacturing a chip structure. The method for manufacturing the chip structure is used to manufacture the chip structure described in the above embodiments. The following embodiments are illustrated by taking the chip structure manufactured by the method is the chip structure shown in FIG. 16 as an example. The method for manufacturing the chip structure includes following processes.

In S201, a dis-adhesive layer is formed on a temporary substrate.

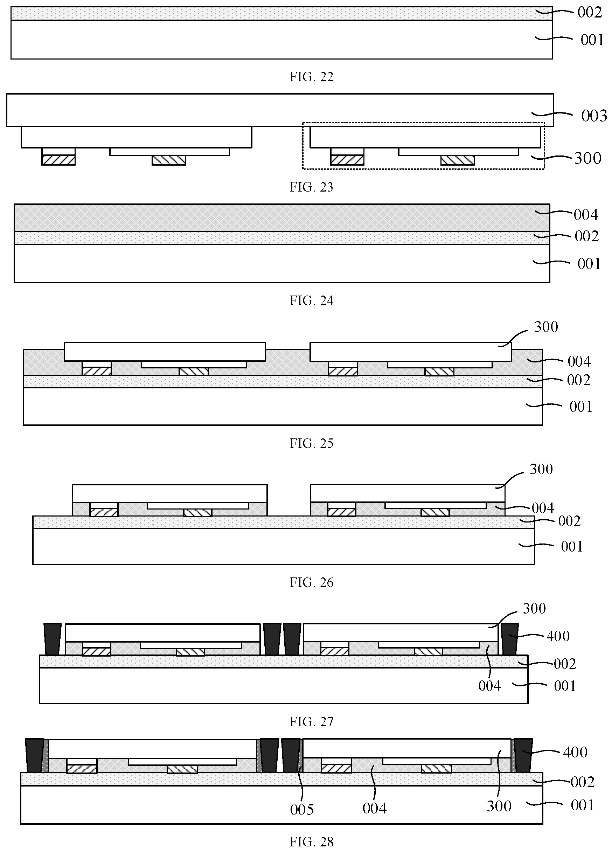

In the embodiments of the present disclosure, as shown in FIG. 22, FIG. 22 is a schematic diagram of formation of a dis-adhesive layer on a temporary substrate according to some embodiments of the present disclosure. A dis-adhesive layer 002 is uniformly coated on a temporary substrate 001. For example, the dis-adhesive layer 002 is decomposed upon exposure to a specific wavelength of light (for example, ultraviolet light and/or laser light) to separate the temporary substrate from the chip structure 000. For example, the dis-adhesive layer 002 is decomposed under heating conditions to separate the temporary substrate from the chip structure 000.

In S202, a plurality of light-emitting units are provided, wherein the plurality of light-emitting units are fixedly arranged on a third substrate.

Illustratively, the third substrate is a growth substrate of the light-emitting unit. Illustratively, the third substrate is a silicon substrate or a sapphire substrate. In the embodiments of the present disclosure, as shown in FIG. 23, FIG. 23 is a schematic diagram of formation of a plurality of light-emitting units on a third substrate according to some embodiments of the present disclosure. A plurality of light-emitting units 300 are formed on the third substrate 003. The first semiconductor layer in each light-emitting unit 300is closer to the third substrate 003 than a welding electrode.

Illustratively, the third substrate is a carrier substrate, and the plurality of light-emitting units are transferred from the growth substrate to the third substrate.

In S203, a first adhesive is provided, the third substrate is overlapped with the temporary substrate to cause the plurality of light-emitting units to be in contact with the first adhesive between the third substrate and the temporary substrate, and the third substrate is removed to form the plurality of light-emitting units on the temporary substrate.

In the embodiments of the present disclosure, sequences of covering the first adhesive on the temporary substrate and overlapping the third substrate with the temporary substrate are not limited, and the two sub-processes are performed sequentially or simultaneously.

In some embodiments, referring to FIG. 24, FIG. 24 is a schematic diagram upon coating of a first adhesive according to some embodiments of the present disclosure. A whole layer first adhesive 004 is uniformly coated on a side, facing away from the temporary substrate 001, of the dis-adhesive layer 002. Then, as shown in FIG. 25, FIG. 25 is a schematic diagram of formation of a plurality of light-emitting units on a temporary substrate according to some embodiments of the present disclosure. The third substrate 003 is overlapped with the temporary substrate 001, such that the sides, facing away from the third substrate 003, of the plurality of light-emitting units 300 are pressed (immersed) in the first adhesive 004 formed on the temporary substrate 001 to cause the plurality of light-emitting units 300 to be connected to the temporary substrate 001. Then, the third substrate 003 is removed (by a wet etching process). The welding electrode in each light-emitting unit 300 is closer to the temporary substrate 001 than the first semiconductor layer.

In some embodiments, the third substrate 003 is first overlapped with the temporary substrate 001, and the first adhesive 004 is filling in a gap between the third substrate and the temporary substrate, such that the plurality of light-emitting units 300 are connected to the temporary substrate 001. Then, the third substrate 003 is removed (by a wet etching process). The welding electrode in each light-emitting unit 300 is closer to the temporary substrate 001 than the first semiconductor layer.

In S204, the first adhesive between two adjacent light-emitting units is removed.

In the embodiments of the present disclosure, as shown in FIG. 26, FIG. 26 is a schematic diagram of removal of a portion between two adjacent light-emitting units in a first adhesive according to some embodiments of the present disclosure. The first adhesive 004 between two adjacent light-emitting units 300 is removed, such that a gap is present between the two adjacent light-emitting units 300.

Illustratively, a side, facing towards the light-emitting units 300, of the temporary substrate 001 is ashed, such that a portion of the first adhesive 004 not covered by the light-emitting units 300 is ashed and removed, and a portion of the first adhesive 004 (or the cured product) covered by the light-emitting units 300 is not ashed and removed. Thus, the light-emitting units 300 are fixedly affixed on a side, facing away from the temporary substrate 001, of the dis-adhesive layer 002 by the remained first adhesive 004 (or the cured product).

It should be noted that the first adhesive 004 on a side, facing towards the temporary substrate 001, of the light-emitting unit 300 forms the second filling sub-portion 502 in the filling portion 500 in the above embodiments.

In S205, the dams surrounding the peripheries of the plurality of light-emitting units are formed on the temporary substrate.

In the embodiments of the present disclosure, as shown in FIG. 27, FIG. 27 is a schematic diagram of formation of dams surrounding peripheries of various light-emitting units on a temporary substrate according to some embodiments of the present disclosure. As the first adhesive is not disposed between two adjacent light-emitting units 300 upon S205, the dams 400 are formed on the peripheries of the plurality of light-emitting units 300. Each dam 400 are in an annular shape, and the light-emitting unit 300 is disposed in a region enclosed by adjacent dams 400.

It should be noted that as the dam 400 is made of an organic material, in the case that a thickness of the dam 400 is great, a shape of a section of the dam 400 is an inverted trapezoid with respect to the temporary substrate 001 upon formation of the dam 400 by exposure and development. That is, a width of a face, facing towards the temporary substrate 001, of the dam 400 is less than a width of a face, facing away from the temporary substrate 001, of the dam 400.

In S206, gaps between the dams and corresponding light-emitting units are filled by a second adhesive.

Illustratively, the second adhesive 005 is a transparent organic resin with high fluidity. The second adhesive 005 is printed in the gap between the dam 400 and the light-emitting unit 300 by an inkjet printing process, and the second adhesive 005 is cured by a curing process (for example, thermal curing) in the case that the second adhesive 005 is printed in the gap between the dam 400 and the light-emitting unit 300.

It should be noted that in the process of printing the second adhesive 005 in the gap between the dam 400 and the light-emitting unit 300 by an inkjet printing process, the second adhesive 005 is only filled in the gap between the dam 400 and the light-emitting unit 300, or, the second adhesive 005 is disposed on a side, facing away from the temporary substrate 001, of the dam 400 and/or a side, facing away from the temporary substrate 001, of the light-emitting unit 300. For example, the second adhesive 005 is disposed between adjacent two dams 400. The second adhesive 005 (or the cured product) between adjacent two dams 400 is removed in the subsequent ashing process.

In the embodiments of the present disclosure, as shown in FIG. 28, FIG. 28 is a schematic diagram of formation of a plurality of planarization portions on a temporary substrate according to some embodiments of the present disclosure. A gap is present between the light-emitting unit 300 and the dam 400 upon formation of dams 400 surrounding the peripheries of the light-emitting units 300 in S206. For convenient formation of the color conversion unit, the second adhesive 005 is filled in the gap between the dam 400 and the corresponding light-emitting unit 300. In the case that the second adhesive 005 is filled in the gap between the dam 400 and the corresponding light-emitting unit 300 and is cured, a plurality of planarization portions are formed on the temporary substrate 001. Each planarization portion includes the dam 400, the corresponding light-emitting unit 300, and the cured product of the second adhesive 500 between the dam 400 and the corresponding light-emitting unit 300. In some embodiments, each planarization portion further includes the dam 400, the corresponding light-emitting unit 300, and the cured product of the second adhesive 500 on a side, away from the temporary substrate 001, of at least one of the dam 400 and the corresponding light-emitting unit 300. In some embodiments, each planarization portion further includes the first adhesive 004 (or the cured product) between the light-emitting unit 300 and the temporary substrate 100. As such, the flatness of the side, facing away from the temporary substrate 001, of the planarization portion is ensured, and the color conversion unit is stably formed on the side, facing away from the temporary substrate 001, of the planarization portion.

It should be further noted that the cured product of the second adhesive in the chip structure 000 is at least the first filling sub-portion 501 in the filling portion 500 in the above embodiments.

For example, in the case that the plurality of light-emitting units 300 are in contact with the first adhesive between the light-emitting unit 300 and the third substrate 003 in S203, the manufacturing method further includes curing the first adhesive 004.

For example, in the case that the plurality of light-emitting units 300 are in contact with the first adhesive between the light-emitting unit 300 and the third substrate 003, the first adhesive 004 is cured, and then the third substrate 003 is removed, such that the light-emitting units 300 are fixedly connected to the temporary substrate by the cured first adhesive 004.

It is understandable that the process of curing the first adhesive 004 is performed prior to or upon other appropriate processes. For example, in the case that the fluidity of the first adhesive 004 is not high, the first adhesive 004 and the second adhesive 005 are cured simultaneously to reduced processes.

Thus, in S204, removal of the portion of the first adhesive between two adjacent light-emitting units is removal of a portion of the cured first adhesive between two adjacent light-emitting units. In the curing process is not performed prior to the process, removal of the portion of the first adhesive between two adjacent light-emitting units is removal of a portion of the not cured first adhesive between two adjacent light-emitting units.

In some embodiments, in the case that the fluidity of the first adhesive 004 is not high, the first adhesive 004 is not cured. In this case, the first adhesive 004 is the second filling sub-portion 502.

In S207, a plurality of color conversion units are formed on a side, facing away from the temporary substrate, of the plurality of light-emitting units.

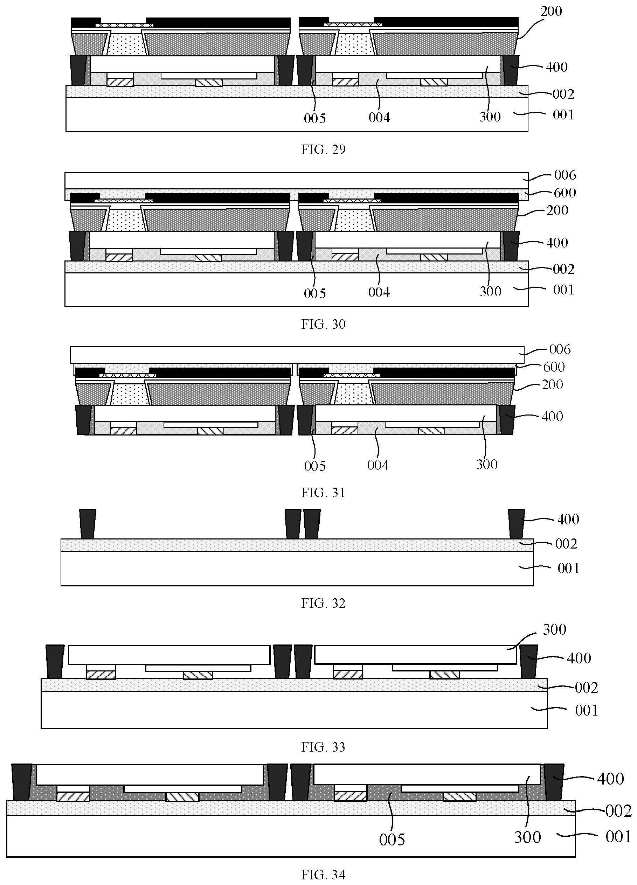

In the embodiments of the present disclosure, as shown in FIG. 29, FIG. 29 is a schematic diagram of formation of color conversion units on a side, facing away from a temporary substrate, of planarization portions according to some embodiments of the present disclosure. As the planarization portion including the dam 400 and the light-emitting unit 300 is formed in S207, and a flatness of the side, facing away from the temporary substrate 100, of the planarization portion is high, the color conversion unit 200 with high stability is formed on the side, facing away from the temporary substrate, of each planarization portion.

Illustratively, S207 includes following sub-processes.

In S2071, a limiting dam is formed on a side, facing away from the temporary substrate, of each of the plurality of planarization portions.

Illustratively, a whole layer limiting dam material layer is formed on sides, facing away from the temporary substrate 001, of the plurality of planarization portions, and a single patterning process is performed on the limiting dam material layer to form the limiting dam 201 on the side, facing away from the temporary substrate 001, of each of the plurality of planarization portions. An opening region K1 is defined in the limiting dam 201 on the side, facing away from the temporary substrate 001, of each of the plurality of planarization portions, and corresponds to the light-emitting functional sub-layer in the light-emitting unit 300 in the corresponding planarization portion.

In S2072, a first encapsulation layer is formed on a side, facing away from the each of the plurality of planarization portions, of the limiting dam.

Illustratively, a first inorganic thin film layer is formed on a planarization portion including the limiting dam 201 by any of deposition, coating, sputtering, and the like, and a single patterning process is performed on the first inorganic film layer to form the first encapsulation layer 203 on the side, facing away from the each of the plurality of planarization portions, of the limiting dam 201. A part of the first encapsulation layer 203 extends in the opening region K1 in the limiting dam 201.

In S2073, an optical functional portion is formed in the opening region.

Illustratively, the optical functional portion 202 is formed in the opening region K1 in the limiting dam 201 by an inkjet printing process.

In S2074, a second encapsulation layer is formed on a side, facing away from the temporary substrate, of the optical functional portion.

Illustratively, a second inorganic thin film layer is formed on the side, facing away from the temporary substrate 001, of the first encapsulation layer 203 by any of deposition, coating, sputtering, and the like, and a single patterning process is performed on the second inorganic film layer to form the second encapsulation layer 204 on the side, facing away from the temporary substrate 001, of the first encapsulation layer 203 and the optical functional portion 202. The second encapsulation layer 204 is in contact with the first encapsulation layer 203 to seal the optical functional portion 202.

In S2075, a light-filtering unit and a light-shielding layer are sequentially formed on a side, facing away from the temporary substrate, of the second encapsulation layer.

Illustratively, the light-filtering unit 206 and the light-shielding layer 205 are sequentially formed on a side, facing away from the temporary substrate, of the second encapsulation layer 203. An aperture K2 corresponding to the light-filtering unit 206 is defined in the light-shielding layer 205, and an orthographic projection of the light-filtering unit 206 on the temporary substrate 001 is overlapped with an orthographic projection of the aperture K2 on the temporary substrate 001.

In the embodiments of the present disclosure, the color conversion unit 200 is formed on each planarization portion by S2071 to S2075. It should be noted that orthographic projections of the first encapsulation layer 203, the second encapsulation layer 204, and the light-shielding layer 204 on the temporary substrate 001 are within a region enclosed by an outer counter of an orthographic projection of the limiting dam 201 on the temporary substrate 001 to ensure great stability of the first encapsulation layer 203, the second encapsulation layer 204, and the light-shielding layer 204 formed on the limiting dam 201.

In S208, a second substrate is formed on a side, facing away from the temporary substrate, of the plurality of color conversion units.

In the embodiments of the present disclosure, as shown in FIG. 30, FIG. 30 is a schematic diagram of formation of a second substrate on a side, facing away from a temporary substrate, of a plurality of color conversion units according to some embodiments of the present disclosure. A transparent connection layer 600 is formed on a side of the second substrate 006, and the second substrate 006 is bonded to the side, facing away from the temporary substrate 001, of the plurality of color conversion units 200 by the transparent connection layer 600. The second substrate indicates an integral substrate with a great area, and the first substrate 100 in the chip structure 000 belongs to the second substrate.

It should be noted that as the second substrate 006 is bonded to various color conversion units 200 by the transparent connection layer 600, a part of the transparent connection layer 600 is filled in the opening region K1 in the light-shielding layer 205 in the color conversion unit 200.

It should be further noted that the transparent connection layer 600 formed on the side of the second substrate 006 is a whole layer film layer structure or a patterned film layer structure. In the case that the second substrate 006 is a patterned film layer structure, the transparent connection layers 600 in one-to-one correspondence with the plurality of color conversion units are formed on the side of the second substrate 006, and each transparent connection layer 600 is connected to the side, facing away from the temporary substrate 001, of the corresponding color conversion unit 200. In the case that the second substrate 006 is a whole layer film layer structure, an excessive part of the transparent connection layer 600 between two adjacent color conversion units 200 is removed in the subsequent ashing process, such that the whole layer transparent connection layer 600 formed on the side of the second substrate 006 does not affect the subsequent cutting process of the second substrate 006.

In S209, the temporary substrate is removed, and a side, facing towards the plurality of color conversion units, of the second substrate is ashed.

In the embodiments of the present disclosure, as shown in FIG. 31, FIG. 31 is a schematic diagram of removal of a temporary substrate according to some embodiments of the present disclosure. For example, a specific wavelength of light irradiates from the side, facing away from the dis-adhesive layer 002, of the temporary substrate 001, such that the dis-adhesive layer 002 is removed (for example, decomposed) under the irradiation of the specific wavelength of light, and the temporary substrate 001 is then peeled off.

Then, a side, facing towards the plurality of color conversion units 200, of the second substrate 006 is ashed to remove a portion of the transparent connection layer 600 between two adjacent color conversion units 200. A portion of the transparent connection layer 600 not covered by the color conversion unit 200 and the planarization portion is ashed. In the ashing process of the side, facing towards the plurality of color conversion units 200, of the second substrate 006, an excessive adhesive on a face on a side, facing away from the second substrate 006, of the welding electrode in the light-emitting unit 300 is removed, and the excessive adhesive is the first adhesive or an adhesive in the dis-adhesive layer, such that the welding electrodes between the drive backplane and the chip structure are greatly connected upon formation of the chip structure and fixation of the chip structure on the drive backplane.

In addition, in the ashing process of the side, facing towards the plurality of color conversion units 200, of the second substrate 006, a side, facing away from the second substrate 006, of the dam 400 and a side, facing away from the second substrate 005, of the filling portion 500 are ashed to remove the part, and an ashed amount in the dam 400 and the filling portion 500 is less.

In S210, the second substrate is cut to acquire a plurality of chip structures.

It should be noted that the chip motherboard is acquired upon S201 to S210. The plurality of chip structures are acquired by cutting the second substrate in the chip motherboard. For the detailed structure of the chip structure, reference may be made to the chip structure in FIG. 16.

Illustratively, the second substrate is cut by laser hidden cutting. In the cutting process, the laser cutting beam is focused to a middle of the second substrate in the thickness direction of the second substrate, such that the middle of the second substrate is melted or vaporized. Then, an action force is applied to the upper and/or lower face of the second substrate with a tool, such that the portion of the second substrate belonging to the first substrate 100 in the chip structure 000 is separated. It should be noted that in the process, the laser cutting beam is focused to the middle of the second substrate, and thus extra debris (for example, cutting Mars) is not generated in the cutting process and is not sputtered to the light-emitting unit 200 or the color conversion unit 300, such that the reliability of the chip structure 000 acquired in subsequently cutting process is great.

The embodiments of the present disclosure further provide a method for manufacturing a chip structure. The method for manufacturing the chip structure is used to manufacture the chip structure described in the above embodiments. The following embodiments are illustrated by taking the chip structure manufactured by the method is the chip structure shown in FIG. 16 as an example. The method for manufacturing the chip structure includes following processes.

In S301, a dis-adhesive layer is formed on a temporary substrate.

For the process, reference may be made to S201, which is not described again.

In S302, a plurality of dams are formed on a side, facing away from a temporary substrate, of the dis-adhesive layer.

In the embodiments of the present disclosure, as shown in FIG. 32, FIG. 32 is a schematic diagram of formation of a plurality of dams on a side, facing away from a temporary substrate, of a dis-adhesive layer according to some embodiments of the present disclosure. The plurality of dams 400 are formed on a side, facing away from a temporary substrate 001, of the dis-adhesive layer 002. Each dam 400 is in an annular shape.

In S303, a plurality of light-emitting units are formed, and at least part of the plurality of formed light-emitting units are transferred to regions enclosed by corresponding dams by a transferring process.

In the embodiments of the present disclosure, as shown in FIG. 33, FIG. 33 is a schematic diagram of transfer of at least part of a plurality of light-emitting units to regions enclosed by corresponding dams according to some embodiments of the present disclosure. The plurality of light-emitting units are first formed. For example, the plurality of light-emitting units are formed on a third substrate. For example, the plurality of light-emitting units are formed on a growth substrate, and are then transferred on the third substrate. The plurality of light-emitting units are formed by purchasing, transferring, and the like. Then, at least part of the plurality of formed light-emitting units 300 are transferred to regions enclosed by corresponding dams 400 by a transferring process. In the transferring process, the dams 400 function as defining, such that the light-emitting units 300 are accurately disposed in the dams 400. Thus, transfer precision is improved, and an impact on the luminous effect of chip structure 000 due to alignment deviation between the optical functional portion 202 and the light-emitting functional sub-layer 300a is avoided in subsequent process of manufacturing the color conversion unit 200.

For example, between S301 and S302, the method further includes forming an adhesive layer on a side, facing away from the temporary substrate, of the dis-adhesive layer. The adhesive layer functions as adhering the transferred light-emitting units and the dissociation layer, such that the light-emitting unit 300 is stable on the temporary substrate. In the subsequent process of ashing the side, facing towards the plurality of color conversion units 200, of the second substrate 006, and the adhesive layer is removed by ashing process.

In some embodiments, the transferring process in the above embodiments is a massive transferring process. Specifically, the plurality of light-emitting units are formed, and at least part of the plurality of formed light-emitting units formed by the massive transferring process are transferred to regions enclosed by corresponding dams.

In some embodiments, at least part of the plurality of formed light-emitting units formed by the transferring process are transferred to regions enclosed by corresponding dams by a transferring process. The to-be-transferred light-emitting units include the cured first adhesive, and the cured first adhesive is between the light-emitting unit and the temporary substrate upon transfer of the light-emitting unit to the region enclosed by corresponding dam. Similar to S203, the light-emitting unit is removed from the growth substrate by bonding and curing through the first adhesive. Then, the cured first adhesive is remained in the light-emitting unit and enters the light-emitting unit in subsequent processes.

In S304, a second adhesive is filled in a gap between the dam and the corresponding light-emitting unit.

Illustratively, as shown in FIG. 34, FIG. 34 is a schematic diagram of filling gaps between various dams and corresponding light-emitting units by a second adhesive according to some embodiments of the present disclosure. The second adhesive 005 is a transparent organic resin with high fluidity. The second adhesive 005 is printed in the gap between the dam 400 and the light-emitting unit 300 by an inkjet printing process, and the second adhesive 005 is cured by a curing process (for example, thermal curing) in the case that the second adhesive 005 is printed in the gap between the dam 400 and the light-emitting unit 300.

It should be noted that in the process of printing the second adhesive 005 in the gap between the dam 400 and the light-emitting unit 300 by an inkjet printing process, the second adhesive 005 is only filled in the gap between the dam 400 and the light-emitting unit 300, or, the second adhesive 005 is disposed on a side, facing away from the temporary substrate 001, of the dam 400 and/or a side, facing away from the temporary substrate 001, of the light-emitting unit 300. For example, the second adhesive 005 is disposed between adjacent two dams 400. The second adhesive 005 (or the cured product) between adjacent two dams 400 is removed in the subsequent ashing process.

As the first adhesive 004 (or the cured product) does not boned in the light-emitting unit 300, and the second adhesive 005 is disposed between the light-emitting unit 300 and the temporary substrate 100. That is, compared with S201 to S206, the filling portion 500 formed by curing the second adhesive is manufactured by the second adhesive by a single process, and is continuous in the gap between the dam 400 and the light-emitting unit 300 and the gap between the light-emitting unit 300 and the temporary substrate 100.

A gap is present between the light-emitting unit 300 and the dam 400 upon transfer of at least part of the plurality of formed light-emitting units 300 to regions enclosed by corresponding dams by a massive transferring process in S303. For convenient formation of the color conversion unit, the second adhesive 005 is filled in the gap between the dam 400 and the corresponding light-emitting unit 300 and the gap between the light-emitting unit 300 and the temporary substrate 100. In the case that the second adhesive 005 is filled in the gap between the dam 400 and the corresponding light-emitting unit 300 and the gap between the light-emitting unit 300 and the temporary substrate 100 and is cured, a plurality of planarization portions are formed on the temporary substrate 001. Each planarization portion includes the dam 400, the corresponding light-emitting unit 300, and the cured product of the second adhesive 500 between the dam 400 and the corresponding light-emitting unit 300. Each planarization portion further includes the dam 400, the corresponding light-emitting unit 300, and the cured product of the second adhesive 500 on a side, away from the temporary substrate 001, of at least one of the dam 400 and the corresponding light-emitting unit 300. As such, the flatness of the side, facing away from the temporary substrate 001, of the planarization portion is ensured, and the color conversion unit is stably formed on the side, facing away from the temporary substrate 001, of the planarization portion.

In S305, a plurality of color conversion units are formed on a side, facing away from the temporary substrate, of the plurality of light-emitting units.

For the process, reference may be made to S207, which is not described again.

In S306, a second substrate is formed on a side, facing away from the temporary substrate, of the plurality of color conversion units.

For the process, reference may be made to S208, which is not described again.

In S307, the temporary substrate is removed, and a side, facing towards the plurality of color conversion units, of the second substrate is ashed.

For the process, reference may be made to S209, which is not described again.

In S308, the second substrate is cut to acquire a plurality of chip structures.

For the process, reference may be made to S210, which is not described again.

In the embodiments of the present disclosure, the light-emitting unit 300 is transferred to the temporary substrate 0001 by the massive transferring process, which is not limited in the present disclosure. For example, the transfer is achieved by electrostatic force, van der Waals force, illumination (including laser illumination), magnetic force, fluid, seal, and the like.

In some embodiments, the massive transferring process in S303 includes following process.

In S3031, a plurality of light-emitting units are provided, wherein the plurality of light-emitting units are fixedly arranged on a third substrate.

Illustratively, the third substrate is a carrier substrate, and the plurality of light-emitting units are transferred from the growth substrate to the third substrate. For example, a side, close to the light-emitting unit, of the third substrate includes a functional adhesive layer. For example, a material of the functional adhesive layer includes ultraviolet reducing adhesive or laser dissociating adhesive. The functional adhesive layer is adhesive-reduced or dissociated under the action of illumination, such that the light-emitting unit is separated from the third substrate to transfer the light-emitting unit.

It should be noted that providing the plurality of light-emitting units includes providing the plurality of light-emitting units on the growth substrate, and transferring the plurality of light-emitting units from the growth substrate to the third substrate. Illustratively, the third substrata is a silicon substrate or a sapphire substrate. For example, an arrangement density of the light-emitting units arranged on the growth substrate is greater than an arrangement density of the light-emitting units arranged on the third substrate. A light-emitting material on the growth substrate is fully used to reduce the overall cost in such transferring process.

In S3032, the third substrate is opposite to the temporary substrate, such that at least part of the plurality of light-emitting units are opposite to the dams, and the plurality of light-emitting units and the dams are disposed between the third substrate and the temporary substrate.

In the embodiments of the present disclosure, the third substrate 003 is opposite to the temporary substrate, such that at least part of the plurality of light-emitting units are opposite to the dams. In some embodiments, the third substrate is close enough to the temporary substrate, such that the distance from the side, close to the temporary substrate, of the light-emitting unit is less than the distance between the first face S1 of the dam 400 and the temporary substrate. As such, the light-emitting unit enters the space defined by the dam, and the position precision of the massive transferring process is improved. In some embodiments, the third substrate is closer to the temporary substrate, and the side, close to the temporary substrate, of the light-emitting unit is in contact with the film layer on the temporary substrate (for example, dis-adhesive layer or the adhesive layer).

At least part of the plurality of light-emitting units are opposite to the dams in following cases. In one case, a number of the light-emitting units on the third substrate and a number of the dam are the same, and the light-emitting units on the third substrate are in one-to-one correspondence with the dams. As such, the light-emitting units are transferred from the third substrate to the temporary substrate in a single process.

In another case, an arrangement density of the light-emitting units arranged on the growth substrate is greater than an arrangement density of the dams arranged on the third substrate. As such, the light-emitting unit opposite to the dam is separated from the third substrate by selective transferring process, and the light-emitting unit not opposite to the dam is not separated from the third substrate. Furthermore, by adjusting the relative positions of the third substrate and the temporary substrate, at least part of the light-emitting unit not separated from the third substrate is opposite to the dam on the new temporary substrate again, and then a massive transferring process is realized on the new temporary substrate, such that the utilization rate of the light-emitting unit is improved, and the cost is reduced.

In S303, at least part of the plurality of light-emitting units are separated from the third substrate and remained on the temporary substrate.

For example, a side, close to the light-emitting unit, of the third substrate includes a functional adhesive layer. For example, a material of the functional adhesive layer includes ultraviolet reducing adhesive. In accordance with different cases in S3032, the functional adhesive layer is adhesive-reduced by overall or local ultraviolet illumination, such that at least part of the plurality of light-emitting units are separated from the third substrate and remained on the temporary substrate. For example, the material of the functional adhesive layer includes laser dissociation adhesive. In accordance with different cases in S3032, the functional adhesive layer is adhesive-reduced by overall or local laser illumination, such that at least part of the plurality of light-emitting units are separated from the third substrate and remained on the temporary substrate.

For example, in the process of adhesive reduction or dissociation of the functional adhesive layer, the pressures in the opposite directions are applied to the third substrate and the temporary substrate simultaneously to achieve a greater transfer effect. In the case that the adhesive layer is disposed on the temporary substrate, the pressures are applied to fully combine the light-emitting unit to the adhesive layer and improve the transfer yield.

For example, in the process of adhesive reduction or dissociation of the functional adhesive layer, the third substrate and/or the temporary substrate is heated simultaneously to achieve a greater transfer effect.

Some embodiments of the present disclosure further provide a display substrate. The display substrate is a display substrate in a mobile phone, a laptop computer, a television, a display substrate of an electronic watch or a flat computer, or a display substrate of an advertising screen. The display substrate includes a drive backplane and a plurality of chip structures. Various second electrode pads and first electrode pads in each chip structure are affixed on the drive backplane by welding to be electrically connected to the drive backplane. It should be noted that the drive backplane supplies corresponding drive signals to various chip structures to drive the light-emitting units in the chip structure to emit light, such that the display substrate displays corresponding display screens.

Some embodiments of the present disclosure further provide a display module. The display module includes a housing, a drive assembly, and a display substrate. The display module is a mobile phone, a laptop computer, a television, a display module of an electronic watch or a flat computer, or a display module of an advertising screen. the display substrate in the module is the display substrate in the above embodiments.

It should be noted that in the accompanying drawings, for clarity of the illustration, the dimension of the layers and regions may be scaled up. It is understandable that when an element or layer is described as being "on" another element or layer, the described element or layer may be directly located on other elements or layers, or an intermediate layer may exist. In addition, it should be understood that when an element or layer is described as being "under" another element or layer, the described element or layer may be directly located under other elements, or more than one intermediate layer or element may exist. In addition, it should be further understood that when a layer or element is described as being arranged "between" two layers or elements, the described layer or element may be the only layer between the two layers or elements, or more than one intermediate layer or element may exist. In the whole disclosure, like reference numerals indicate like elements.

For example, the terms "first" and "second" are only intended to describe, and are not intended to indicate or imply relative importance. The term "a plurality of " herein means two or more, unless otherwise defined clearly.

Described above are merely optional embodiments of the present disclosure, and are not intended to limit the present disclosure. Any modifications, equivalent replacements, improvements and the like made within the spirit and principles of the present disclosure should be encompassed within the scope of protection of the present disclosure.

## Claims

1. A chip structure, comprising: a first substrate, light-emitting units, color conversion units, and a dam; wherein
the color conversion units are disposed between the first substrate and the light-emitting units, light-emitting sides of the light-emitting units face towards the first substrate, and the dam is disposed on a side, facing away from the first substrate, of each of the color conversion units and surrounds a periphery of each of the light-emitting units;
each of the color conversion units comprises a limiting dam and an optical functional portion, wherein an opening region is defined in the limiting dam, and the optical functional portion is disposed in the opening region and is configured to convert a color of light entering the optical functional portion; and
an orthographic projection of the dam on the first substrate has a first outer contour, and an orthographic projection of the limiting dam on the first substrate has a second outer contour, wherein the second outer contour is disposed in a region enclosed by the first outer contour.

2. The chip structure according to claim 1, wherein a section of the dam perpendicular to the first substrate and perpendicular to an extension direction of the dam comprises a first edge facing towards a side of the first substrate and a second edge facing away from the side of the first substrate, wherein a length of the first edge is greater than a length of the second edge.

3. The chip structure according to claim 2, wherein the dam has a first face facing towards the side of the first substrate and a second face facing away from the side of the first substrate, and further has a first outer contour face between the first face and the second face, wherein an angle between the first face and the first outer contour face is an acute angle, and an angle between the second face and the first outer contour face is an obtuse angle.

4. The chip structure according to claim 1, wherein the dam has a first face facing towards the side of the first substrate and a second face facing away from the side of the first substrate, wherein an orthographic projection of the second face on the first substrate is within an orthographic projection of the first face on the first substrate.

5. The chip structure according to claim 1, wherein
the dam has a first face facing towards the side of the first substrate and a second face facing away from the side of the first substrate, and further has a first inner contour face between the first face and the second face; and
the chip structure further comprises a filling portion, wherein at least part of the filling portion is disposed in a region enclosed by the dam, a part of the filling portion is disposed between the light-emitting units and the first inner contour face and another part of the filling portion is disposed on a side, away from the first substrate, of the light-emitting units, and the filling portion is in contact with the first inner contour face and the light-emitting units.

6. The chip structure according to claim 5, wherein the filling portion comprises a first filling sub-portion and a second filling sub-portion; wherein at least part of the first filling sub-portion is disposed between the light-emitting units and the first inner contour face, the second filling sub-portion is disposed on the side, away from the first substrate, of the light-emitting units, the first filling sub-portion is in contact with the first inner contour face and the second filling sub-portion, and the second filling sub-portion is in contact with the light-emitting units.

7. The chip structure according to claim 5, wherein a minimum distance between the filling portion and the first substrate is greater than a distance between the first face and the first substrate; or, a part of the filling portion is disposed on a side, close to the first substrate, of the first face.

8. The chip structure according to claim 5, wherein a minimum distance between the filling portion and the first substrate is greater than a distance between the light-emitting units and the first substrate; or, a part of the filling portion is disposed on a side, close to the first substrate, of each of the light-emitting units.

9. The chip structure according to claim 5, wherein the limiting dam is in direct contact with the dam, and/or, the limiting dam is in direct contact with each of the light-emitting units.

10. The chip structure according to claim 5, wherein the limiting dam has a third face facing towards the side of the first substrate and a fourth face facing away from the side of the first substrate, a part of the filling portion is disposed on a side, close to the first substrate, of the first face, and the part of the filling portion on the side, close to the first substrate, of the first face comprises a first sub-portion covered by the fourth face and a second sub-portion not covered by the fourth face, wherein the second sub-portion surrounds the first sub-portion.

11. The chip structure according to claim 5, wherein the limiting dam has a third face facing towards the side of the first substrate and a fourth face facing away from the side of the first substrate; wherein the fourth face comprises a first region and a second region; wherein
the first region is opposite to the first face and extends along the first face, and the second region is opposite to the light-emitting units and extends along a face on a side, close to the first substrate, of each of the light-emitting units; and
a distance between the first region and the first substrate is greater than a distance between the second region and the first substrate; or, a distance between the first region and the first substrate is less than a distance between the second region and the first substrate.

12. The chip structure according to claim 11, wherein the fourth face further comprises a third region opposite to a part of the filling portion between each of the light-emitting units and the dam, wherein at least one of a distance between the third region and the first substrate, the distance between the first region and the first substrate, or the distance between the second region and the first substrate is different from other distances.

13. The chip structure according to claim 5, wherein each of the light-emitting units comprises a connection electrode, wherein the connection electrode is disposed on a side, furthest from the first substrate, of the each of the light-emitting units, and a distance between a face, away from the first substrate, of the connection electrode and the first substrate is greater than a distance between the second face and the first substrate.

14. The chip structure according to claim 5, wherein a distance between the second face and the first substrate is greater than a distance between a face, away from the first substrate, of the part of the filling portion between the dam and each of the light-emitting units and the first substrate.

15. The chip structure according to claim 5, wherein the first face comprises an inner contour edge on a side close to the light-emitting units and an outer contour edge on a side away from the light-emitting units, wherein a distance between the contour edge and the first substrate is greater than a distance between the outer contour edge and the first substrate.

16. The chip structure according to claim 5, wherein
the light-emitting units comprises a first semiconductor layer, wherein a distance between a first pair of feature points furthest from each other in a face on a side, facing towards the first substrate, of the first semiconductor layer is a first distance D1;
a second pair of feature points corresponding to the first pair of feature points are present in an inner region enclosed by an orthographic projection of the first inner contour face on the first substrate, a distance between the second pair of feature points is a second distance D2, and the second pair of feature points indicate a pair of feature points intercepted by a straight line of an orthographic projection of the first pair of feature points on the first substrate in an outer contour of the inner region enclosed by the orthographic projection of the first inner contour face on the first substrate, wherein the second distance D2 and the first distance D1 meet that a value of (D2-D1) is less than or equal to 30 microns.

17. The chip structure according to claim 1, wherein for accommodation spaces enclosed by the dam for accommodating the light-emitting units, areas of various sections of inner of the accommodation spaces in an extension face parallel to the first substrate are increasingly reduced in a direction from the first substrate to the dam.

18. The chip structure according to claim 17, wherein a shape of a section of the dam perpendicular to the first substrate and perpendicular to an extension direction of the dam is at least one of an inverted trapezoid, an inverted triangle, or an inverted circular arc relative to the first substrate.

19. The chip structure according to claim 1, wherein the limiting dam has a third face facing towards a side of the first substrate and a fourth face facing away from the side of the first substrate, wherein an orthographic projection of the fourth face on the first substrate is within an orthographic projection of the third face on the first substrate.

20. The chip structure according to claim 1, wherein the limiting dam has a third face facing towards a side of the first substrate, a fourth face facing away from the side of the first substrate, and a second outer contour face between the third face and the fourth face, wherein the second outer contour face is in contact with an external environment.

21. The chip structure according to claim 1, wherein each of the color conversion units further comprises a first encapsulation layer between the first substrate and the limiting dam, wherein a part of the first encapsulation layer is disposed in the opening region, the optical functional portion is disposed between the first encapsulation layer and the first substrate, and an orthographic projection of the optical functional portion on the first substrate is within an orthographic projection of the first encapsulation layer on the first substrate.

22. The chip structure according to claim 21, wherein the first encapsulation layer is in direct contact with the light-emitting units.

23. The chip structure according to claim 21, wherein
each of the color conversion units further comprises a second encapsulation layer between the first substrate and the first encapsulation layer, wherein the optical functional portion is disposed between the first encapsulation layer and the second encapsulation layer, the first encapsulation layer is in direct contact with the second encapsulation layer to seal the optical functional portion; and
each of the color conversion units further comprises a light-shielding layer between the first substrate and the limiting dam, wherein an aperture is defined in the light-shielding layer, wherein an orthographic projection of the opening region on the first substrate is overlapped with an orthographic projection of the aperture on the first substrate.

24. The chip structure according to claim 23, wherein each of the color conversion units further comprises a light-filtering unit between the first substrate and the optical functional portion, wherein an orthographic projection of the light-filtering unit on the first substrate is overlapped with an orthographic projection of a corresponding aperture on the first substrate.

25. The chip structure according to claim 21, wherein the light-shielding layer has a fifth face facing towards a side of the first substrate, a sixth face facing away from the first substrate, and a third outer contour face between the fifth face and the sixth face, wherein the third outer contour face is in contact with an external environment.

26. The chip structure according to claim 1, further comprising: a transparent connection layer, wherein the transparent connection layer is configured to connect the first substrate to the color conversion units.

27. The chip structure according to claim 26, wherein an orthographic projection of the transparent connection layer on the first substrate is within the first substrate, and a gap is present between an outer contour of the orthographic projection of the transparent connection layer on the first substrate and an outer contour of the first substrate.

28. The chip structure according to claim 26, wherein an outer contour of an orthographic projection of the transparent connection layer on the first substrate and the first outer contour extend in parallel.

29. The chip structure according to claim 1, wherein a face, facing towards the first substrate, of the optical functional portion is a cambered face, and extends along a face on a side, close to the first substrate, of each of the light-emitting units.

30. The chip structure according to any one of claims 1 to 29, wherein each of the light-emitting units comprises a plurality of light-emitting functional sub-layers and a first semiconductor layer on light-emitting sides of the plurality of light-emitting functional sub-layers, wherein the first semiconductor layer comprises a plurality of connection portions in one-to-one correspondence with the plurality of light-emitting functional sub-layers, and an auxiliary portion connected to the plurality of connection portions, wherein the plurality of connection portions are connected to corresponding light-emitting functional sub-layers, at least part of the auxiliary portion is disposed between adjacent connection portions, and the auxiliary portion and the plurality of connection portions are of an integral structure.

31. The chip structure according to claim 30, wherein each of the color conversion units further comprises a plurality of optical functional portions, and a plurality of opening regions are defined in the limiting dam, wherein the plurality of optical functional portions are in one-to-one correspondence with the plurality of opening regions, and each of the plurality of optical functional portions is disposed in a corresponding opening region; and the plurality of optical functional portions are in one-to-one correspondence with the plurality of light-emitting functional sub-layers, and a light-emitting side of each of the plurality of light-emitting functional sub-layers faces towards a corresponding optical functional portion.

32. The chip structure according to claim 31, wherein each of the color conversion units further comprises a light-absorbing layer between the limiting dam and the first substrate, wherein a plurality of apertures in one-to-one correspondence with the plurality of opening regions are defined in the light-absorbing layer, wherein an orthographic projection of each of the plurality of apertures on the first substrate is overlapped with an orthographic projection of a corresponding opening region on the first substrate.

33. The chip structure according to claim 32, wherein each of the color conversion units further comprises a plurality of light-filtering units, wherein the plurality of light-filtering unitsare in one-to-one correspondence with the plurality of optical functional portions and the plurality of apertures, wherein each of the plurality of light-filtering units is disposed between a corresponding optical functional portion and the first substrate, and an orthographic projection of each of the plurality of light-filtering units on the first substrate is overlapped with an orthographic projection of a corresponding aperture on the first substrate.

34. The chip structure according to any one of claims 31 to 33, wherein
the plurality of light-emitting functional sub-layers comprise a first light-emitting functional sub-layer, a second light-emitting functional sub-layer, and a third light-emitting functional sub-layer; and
the plurality of opening regions comprise a first opening region, a second opening region, and a third opening region, wherein the first opening region is opposite to the first light-emitting functional sub-layer, the second opening region is opposite to the second light-emitting functional sub-layer, and the third opening region is opposite to the third light-emitting functional sub-layer;
wherein the first opening region and the second opening region are arranged in a line in a first direction, and the second opening region and the third opening region are arranged in a line in a second direction, wherein the first direction is intersected with the second direction.

35. The chip structure according to any one of claims 31 to 33, wherein each of the color conversion units further comprises a first connection electrode and a plurality of second connection electrodes, wherein the first connection electrode is electrically connected to the first semiconductor layer, and the plurality of second connection electrodes are in one-to-one correspondence with the plurality of light-emitting functional sub-layers, are disposed on a side, facing away from the first semiconductor layer, of corresponding light-emitting functional sub-layers, and are electrically connected to the corresponding light-emitting functional sub-layers.

36. The chip structure according to claim 35, wherein
the plurality of second connection electrodes are in one-to-one correspondence with the plurality of connection portions, and an orthographic projection of each of the plurality of connection portions on the first substrate is overlapped with an orthographic projection of a corresponding second connection electrode on the first substrate; and
the auxiliary portion comprises a first auxiliary portion, a second auxiliary portion, and a third auxiliary portion, wherein an orthographic projection of the first auxiliary portion on the first substrate is overlapped with an orthographic projection of the first connection electrode on the first substrate; a part of the second auxiliary portion is disposed between adjacent connection portions, and another part of the second auxiliary portion is disposed between the first auxiliary portion and each of the plurality of connection portions; and the third auxiliary portion surrounds the first auxiliary portion, the second auxiliary portion, and the plurality of connection portions, wherein the auxiliary portion and the plurality of connection portions are made of a same material.

37. The chip structure according to claim 35, wherein
each of the color conversion units further comprises a common electrode layer connected to the auxiliary portion in the first semiconductor layer, wherein a side, facing away from the first semiconductor layer, of the common electrode layer is lapped with the first connection electrode; and
each of the plurality of light-emitting functional sub-layers comprises a current diffusion layer, a second semiconductor layer, and a light-emitting layer that are laminated in a direction perpendicular to and facing towards the first substrate, wherein a side, facing towards the first substrate, of the light-emitting layer is connected to a corresponding connection portion in the first semiconductor layer, and a side, facing away from the first substrate, of the current diffusion layer is lapped with the plurality of second connection electrodes.

38. The chip structure according to claim 36, wherein each of the color conversion units further comprises an insulative protecting layer on a side, facing away from the first semiconductor layer of a common electrode layer and the plurality of light-emitting functional sub-layers, wherein orthographic projections of the plurality of light-emitting functional sub-layers and the common electrode layer on the first semiconductor layer are within an orthographic projection of the insulative protecting layer on the first semiconductor layer, the first connection electrode and the plurality of second connection electrodes and disposed on a side, facing away from the first semiconductor layer, of the insulative protecting layer, and a first connection via corresponding to the first connection electrode and a plurality of second connection vias in one-to-one correspondence with the plurality of second connection electrodes are defined in the insulative protecting layer, wherein the first connection electrode is lapped with the common electrode layer through the first connection via, and each of the plurality of second connection electrodes is lapped with a current diffusion layer in a corresponding light-emitting functional sub-layer through a corresponding second connection via.

39. The chip structure according to any one of claims 31 to 33 and 35 to 38, wherein
the first semiconductor layer comprises a first sub-layer and a second sub-layer that are laminated in a direction perpendicular to and facing towards the first substrate, wherein the first sub-layer is disposed between the second sub-layer and a light-emitting layer and is made of N-type gallium nitride, and the second sub-layer is a gallium nitride buffer layer; and
a second semiconductor layer is made of P-type gallium nitride, and the light-emitting layer is a multi-quantum well layer.

40. A method for manufacturing a chip structure, applicable to manufacturing the chip structure as defined in any one of claims 1 to 39, the method comprising:
forming a plurality of light-emitting units and dams surrounding peripheries of the plurality of light-emitting units on a temporary substrate;
forming a plurality of color conversion units on a side, facing away from the temporary substrate, of the plurality of light-emitting units;
forming a second substrate on a side, facing away from the temporary substrate, of the plurality of color conversion units; and
removing the temporary substrate, and cutting the second substrate to acquire a plurality of chip structures.

41. The method according to claim 40, wherein forming the plurality of light-emitting units and the dams surrounding the peripheries of the plurality of light-emitting units on the temporary substrate comprises:
providing the plurality of light-emitting units, wherein the plurality of light-emitting units are fixedly arranged on a third substrate;
providing a first adhesive, overlapping the third substrate with the temporary substrate to cause the plurality of light-emitting units to be in contact with the first adhesive between the third substrate and the temporary substrate, and removing the third substrate to form the plurality of light-emitting units on the temporary substrate;
removing the first adhesive between two adjacent light-emitting units; and
forming the dams surrounding the peripheries of the plurality of light-emitting units on the temporary substrate.

42. The method according to claim 40, wherein forming the plurality of light-emitting units and the dams surrounding the peripheries of the plurality of light-emitting units on the temporary substrate comprises:
forming a plurality of dams on the temporary substrate; and
forming the plurality of light-emitting units, and transferring at least part of the plurality of formed light-emitting units to regions enclosed by corresponding dams by a transferring process.

43. The method according to any one of claims 40 to 42, wherein prior to forming the plurality of color conversion units on the side, facing away from the temporary substrate, of the plurality of light-emitting units, the method further comprises:
filling gaps between the dams and corresponding light-emitting units by a second adhesive to form a plurality of planarization portions on the temporary substrate, wherein each of the plurality of planarization portions comprises the dams and the corresponding light-emitting units, and the second adhesive between the dams and the light-emitting units.

44. The method according to claim 43, wherein forming the plurality of color conversion units on the side, facing away from the temporary substrate, of the plurality of light-emitting units comprises:
forming a limiting dam on a side, facing away from the temporary substrate, of each of the plurality of planarization portions, wherein an opening region is defined in the limiting dam;
forming a first encapsulation layer on a side, facing away from the each of the plurality of planarization portions, of the limiting dam, wherein a part of the first encapsulation layer extends in the opening region;
forming an optical functional portion in the opening region; and
forming a second encapsulation layer on a side, facing away from the temporary substrate, of the optical functional portion, wherein the second encapsulation layer is in contact with the first encapsulation layer to seal the optical functional portion.

45. The method according to any one of claims 40 to 42, wherein forming the second substrate on the side, facing away from the temporary substrate, of the plurality of color conversion units comprises:
forming a transparent connection layer on a side of the second substrate; and
bonding the second substrate to a side, facing away from the temporary substrate, of the plurality of color conversion units by the transparent connection layer.

46. The method according to claim 45, wherein upon removing the temporary substrate, the method further comprises:
ashing a side, facing towards the plurality of color conversion units, of the second substrate to remove a portion of the transparent connection layer between two adjacent color conversion units.

47. A display substrate, comprising: a drive backplane and a plurality of chip structures arranged in an array on a side of the drive backplane, wherein each of the plurality of chip structures are the chip structure as defined in any one of claims 1 to 39.
